# EUROPEAN PATENT SPECIFICATION

(11) **EP 4 007 093 B1**
(45) Date of publication and mention of the grant of the patent: **20.11.2024**
(21) Application number: 20848124.2
(22) Date of filing: 15.07.2020
(51) Int. Cl.: H01S 5/183, H01S 5/40, G01S 7/484

(54) **LIGHT-EMITTING ELEMENT AND RANGING DEVICE**
LICHTEMITTIERENDES ELEMENT UND ENTFERNUNGSMESSVORRICHTUNG
ÉLÉMENT ÉLECTROLUMINESCENT ET DISPOSITIF DE TÉLÉMÉTRIE

(30) Priority: 30.07.2019 JP 2019140159
(43) Date of publication of application: 01.06.2022
(73) Proprietor: Sony Semiconductor Solutions Corporation, Atsugi-shi Kanagawa 243-0014 (JP)
(72) Inventor: KOBAYASHI, Takashi, Atsugi-shi, Kanagawa 243-0014 (JP); WAKABAYASHI, Kazuya, Atsugi-shi, Kanagawa 243-0014 (JP); KIMURA, Motoi, Atsugi-shi, Kanagawa 243-0014 (JP); OIWA, Tatsuya, Atsugi-shi, Kanagawa 243-0014 (JP)
(74) Representative: D Young & Co LLP
(86) International application number: PCT/JP2020/027524
(87) International publication number: WO 2021/020134

(56) References cited:
- JP-A- 2008 277 615
- JP-A- 2008 277 780
- JP-A- 2008 277 780
- JP-A- 2012 028 412
- JP-A- 2016 025 289
- US-A1- 2015 229 912
- US-A1- 2015 229 912
- US-A1- 2019 097 397
- US-A1- 2019 109 436
- US-A1- 2019 109 436

## Description

### Technical Field

The present technology relates to a light-emitting element that has a vertical-cavity surface-emitting laser structure, and a ranging apparatus.

### Background Art

A time-of-flight (ToF) method is a ranging method. In the TOF method, light is emitted by a light emitter, and the light reflected off a measurement-target object is detected by a detector. This makes it possible to measure a three-dimensional shape of the measurement-target object.

For example, a ranging method is known that includes diffusing, by a diffusion plate, pieces of light that respectively exit a plurality of light emitters, irradiating the diffused pieces of light onto a measurement-target range, and detecting the reflected pieces of light by a light detector that includes two dimensionally arranged light-receiving/emitting sections. In this ranging method, exiting light is diffused by a diffusion plate. Thus, a short-distance measurement can be performed over a range of light. However, this ranging method is not suitable for a long-distance measurement.

On the other hand, Patent Literature 1 discloses a ranging method including collimating pieces of light that exit a plurality of light emitters (forming the pieces of light into pieces of parallel light) using a lens; and irradiating the entirety of an irradiation range with beams of the pieces of light respectively exiting the plurality of light emitters. This method is suitable for a long-distance measurement since exiting light is formed into a beam.

### Citation List

### Patent Literature

Patent Literature 1: US 2007/0181810 A1

Previously proposed arrangements are disclosed in US 2019/109436 A1, which discloses a two-dimensional array of vertical cavity surface emitting laser elements.

### Disclosure of Invention

### Technical Problem

However, a detector that detects light reflected off a measurement-target object has the property of having a high light-receiving sensitivity for light that enters from a direction vertical to the detector and having a low light-receiving sensitivity for light that enters from a direction oblique to the detector. Thus, there is a problem in which there is a reduction in the accuracy in ranging performed with respect to a surrounding portion in a measurement-target range.

In view of the circumstances described above, it is an object of the present technology to provide a light-emitting element that has a vertical-cavity surface-emitting laser structure and is suitable for a long-distance light irradiation, and a ranging apparatus.

### Solution to Problem

In order to achieve the object described above, a light-emitting element according to an embodiment of the present technology includes a plurality of light emitters, a first electrode terminal, and a second electrode terminal.

The plurality of light emitters is a plurality of light emitters one-dimensionally or two-dimensionally arranged in a direction that is vertical to an optical axis corresponding to light that exits each of the plurality of light emitters, each of the plurality of light emitters being a vertical-cavity surface-emitting laser element, each of the plurality of light emitters including a first electrode and a second electrode, each of the plurality of light emitters emitting the light due to current flowing from the first electrode to the second electrode.

The first electrode terminal is electrically connected to the first electrode.

The second electrode terminal is electrically connected to the second electrode.

A current path from the first electrode terminal to the second electrode terminal that passes through one of the plurality of light emitters exhibits an electrical resistance different from an electrical resistance of a current path from the first electrode terminal to the second electrode terminal that passes through another of the plurality of light emitters.

The light-emitting element may have a central region and a surrounding region, as viewed from a direction extending in parallel with the optical axis, the central region including the light emitter situated in an inner portion of the plurality of light emitters, the surrounding portion including the light emitter situated in an outer portion of the plurality of light emitters, and
the current path passing through the light emitter being included in the plurality of light emitters and being situated in the central region may exhibit a higher electrical resistance than the current path passing through the light emitter being included in the plurality of light emitters and being situated in the surrounding region.

Each of the plurality of light emitters may include a first distributed Bragg reflector (DBR) layer that is electrically connected to the first electrode; a second DBR layer that is electrically connected to the second electrode; a current confinement layer that is arranged between the first DBR layer and the second DBR layer; and an active layer that is arranged between the first DBR layer and the second DBR layer, and emits light due to current on which confinement has been performed by the current confinement layer,
the current confinement layer may have a confinement region, and an injection region that has a higher conductivity than the confinement region, and
the electrical resistance of the current path of the light emitter of the plurality of light emitters may differ depending on a size of an aperture diameter that is a diameter of the injection region.

Each of the plurality of light emitters may have a mesa structure in which at least the first DBR layer, the current confinement layer, and the active layer of the light emitter of the plurality of light emitters are spaced from at least the first DBR layer, the current confinement layer, and the active layer of the adjacent light emitter of the plurality of light emitters, and
the size of the aperture diameter may differ depending on a size of a mesa diameter.

Wiring that connects the first electrode terminal and one of the plurality of light emitters may exhibit an electrical resistance different from an electrical resistance of wiring that connects the first electrode terminal and another of the plurality of light emitters.

The light-emitting element may have a central region and a surrounding region, as viewed from a direction extending in parallel with the optical axis, the central region including the light emitter situated in an inner portion of the plurality of light emitters, the surrounding portion including the light emitter situated in an outer portion of the plurality of light emitters, and
wiring that connects the first electrode terminal and the light emitter being included in the plurality of light emitters and being situated in the central region may exhibit an electrical resistance different from an electrical resistance of wiring that connects the first electrode terminal and the light emitter being included in the plurality of light emitters and being situated in the surrounding region.

The wiring connecting the first electrode terminal and the light emitter being included in the plurality of light emitters and being situated in the central region may exhibit a higher electrical resistance than the wiring connecting the first electrode terminal and the light emitter being included in the plurality of light emitters and being situated in the surrounding region.

The wiring connecting the first electrode terminal and the light emitter being included in the plurality of light emitters and being situated in the central region may be longer than the wiring connecting the first electrode terminal and the light emitter being included in the plurality of light emitters and being situated in the surrounding region.

The plurality of light emitters may be arranged in a plurality of lines, and
the light emitters of the plurality of light emitters in each of the plurality of lines may be connected to a corresponding one of a plurality of the pieces of wiring each extending from the first electrode.

The plurality of the pieces of wiring may include wiring that extends from the first electrode terminal to the central region through the surrounding region, and wiring that extends from the first electrode terminal to the surrounding region, and
the wiring extending to the central region and the wiring extending to the surrounding region may exhibit different electrical resistances.

The wiring extending to the surrounding region may have a larger cross-sectional area than the wiring extending to the central region.

The first electrode included in the one of the plurality of light emitters may exhibit a contact resistance different from a contact resistance of the first electrode included in the other of the plurality of light emitters.

Each of the plurality of light emitters may include a first DBR layer that is electrically connected to the first electrode; a second DBR layer that is electrically connected to the second electrode; a current confinement layer that is arranged between the first DBR layer and the second DBR layer; and an active layer that is arranged between the first DBR layer and the second DBR layer, and emits light due to current on which confinement has been performed by the current confinement layer,
each of the plurality of light emitters may have a mesa structure in which, using a separation groove, at least the first DBR layer, the current confinement layer, and the active layer of the light emitter of the plurality of light emitters are spaced from at least the first DBR layer, the current confinement layer, and the active layer of the adjacent light emitter of the plurality of light emitters, and
the separation groove provided around the one of the plurality of light emitters may have a depth different from a depth of the separation groove provided around the other of the plurality of light emitters.

In order to achieve the object described above, a light-emitting element according to an embodiment of the present technology includes a plurality of light emitters, a first electrode terminal, and a second electrode terminal.

The plurality of light emitters is a plurality of light emitters one-dimensionally or two-dimensionally arranged in a direction that is vertical to an optical axis corresponding to light that exits each of the plurality of light emitters, each of the plurality of light emitters being a vertical-cavity surface-emitting laser element, each of the plurality of light emitters including a first electrode and a second electrode, each of the plurality of light emitters emitting the light due to current flowing from the first electrode to the second electrode.

The first electrode terminal is electrically connected to the first electrode.

The second electrode terminal is electrically connected to the second electrode.

One of the plurality of light emitters has a light extraction efficiency different from a light extraction efficiency of another of the plurality of light emitters.

The light-emitting element may have a central region and a surrounding region, as viewed from a direction extending in parallel with the optical axis, the central region including the light emitter situated in an inner portion of the plurality of light emitters, the surrounding portion including the light emitter situated in an outer portion of the plurality of light emitters, and
the light emitter being included in the plurality of light emitters and being situated in the central region may have a lower light extraction efficiency than the light emitter being included in the plurality of light emitters and being situated in the surrounding region.

A surface coating layer may be formed on a light exiting surface of each of the plurality of light emitters, and
the surface coating layer of the one of the plurality of light emitters may have a thickness different from a thickness of the surface coating layer of the other of the plurality of light emitters.

A surface coating layer that includes a first region and a second region may be provided on a light exiting surface of each of the plurality of light emitters, the second region having optical characteristics different from optical characteristics of the first region, and
a position of a boundary between the first region and the second region in the one of the plurality of light emitters may be different from a position of a boundary between the first region and the second region in the other of the plurality of light emitters.

Each of the plurality of light emitters may include a first DBR layer that is electrically connected to the first electrode; a second DBR layer that is electrically connected to the second electrode; a current confinement layer that is arranged between the first DBR layer and the second DBR layer; and an active layer that is arranged between the first DBR layer and the second DBR layer, and emits light due to current on which confinement has been performed by the current confinement layer, and
reflectance of the first DBR layer of the one of the plurality of light emitters and reflectance of the second DBR layer of the one of the plurality of light emitters may be respectively different from reflectance of the first DBR layer of the other of the plurality of light emitters and reflectance of the second DBR layer of the other of the plurality of light emitters.

A distribution of light-emission intensities of the plurality of light emitters from the central region to the surrounding region may have a shape represented by cosⁿθ.

In order to achieve the object described above, a ranging apparatus according to an embodiment of the present technology includes a light-emitting unit, a light-receiving unit, and a ranging calculation section.

The light-emitting unit includes a light-emitting element including
a plurality of light emitters one-dimensionally or two-dimensionally arranged in a direction that is vertical to an optical axis corresponding to light that exits each of the plurality of light emitters, each of the plurality of light emitters being a vertical-cavity surface-emitting laser element, each of the plurality of light emitters including a first electrode and a second electrode, each of the plurality of light emitters emitting the light due to current flowing from the first electrode to the second electrode,
a first electrode terminal that is electrically connected to the first electrode, and
a second electrode terminal that is electrically connected to the second electrode, in which
a current path from the first electrode terminal to the second electrode terminal that passes through one of the plurality of light emitters exhibits an electrical resistance different from an electrical resistance of a current path from the first electrode terminal to the second electrode terminal that passes through another of the plurality of light emitters.

The light-receiving unit detects reflected light that is light exiting the light-emitting unit.

The ranging calculation section calculates a distance to a measurement target on the basis of a result of the detection performed by the light-receiving unit.

### Brief Description of Drawings

[Fig. 1] Fig. 1 is a block diagram illustrating a configuration of a ranging apparatus according to embodiments of the present technology.
[Fig. 2] Fig. 2 is a schematic diagram illustrating a positional relationship between a light-emitting unit, a light-receiving unit, and a measurement target, the light-emitting unit and the light-receiving unit being included in the ranging apparatus.
[Fig. 3] Fig. 3 is a schematic diagram of the light-emitting unit.
[Fig. 4] Fig. 4 is a perspective view of a light-emitting element included in the light-emitting unit.
[Fig. 5] Fig. 5 is a schematic diagram illustrating light that exits the light-emitting element.
[Fig. 6] Fig. 6 is a cross-sectional view of the light-emitting element.
[Fig. 7] Fig. 7 is a cross-sectional view of a portion of a configuration of the light-emitting element.
[Fig. 8] Fig. 8 is a plan view of a light emitter included in the light-emitting element.
[Fig. 9] Fig. 9 is a plan view of an anode included in the light-emitting element.
[Fig. 10] Fig. 10 is a plan view of a cathode included in the light-emitting element.
[Fig. 11] Fig. 11 is a schematic diagram illustrating an angle of incidence of reflected light on the light-receiving unit included in the ranging apparatus.
[Fig. 12] Fig. 12 is a schematic diagram illustrating (two-dimensional) regions in the light-emitting element.
[Fig. 13] Fig. 13 is a schematic diagram illustrating (one-dimensional) regions in the light-emitting element.
[Fig. 14] Fig. 14 is a circuit diagram illustrating an equivalent circuit of one light emitter in the light-emitting element.
[Fig. 15] Fig. 15 is a circuit diagram illustrating an equivalent circuit of the light emitters in respective regions in the light-emitting element.
[Fig. 16] Fig. 16 is a schematic diagram illustrating an aperture diameter of the light emitter included in the light-emitting element.
[Fig. 17] Fig. 17 is a graph illustrating a relationship between current and voltage that is caused due to the aperture diameter of the light emitter.
[Fig. 18] Fig. 18 is a graph illustrating a relationship between current and light output that is caused due to the aperture diameter of the light emitter.
[Fig. 19] Fig. 19 is a graph illustrating a relationship between voltage and light output that is caused due to the aperture diameter of the light emitter.
[Fig. 20] Fig. 20 is a schematic diagram illustrating the aperture diameter of the light emitter for each region.
[Fig. 21] Fig. 21 is a schematic diagram illustrating a difference in aperture diameter between the light emitters due to the width of a confinement region.
[Fig. 22] Fig. 22 is a schematic diagram illustrating a difference in aperture diameter between the light emitters due to mesa diameter.
[Fig. 23] Fig. 23 is a plan view illustrating wiring that connects the anodes and each light emitter in the light-emitting element.
[Fig. 24] Fig. 24 is a circuit diagram illustrating the equivalent circuit of the light emitters in the respective regions in the light-emitting element, where wiring resistances have been added to the equivalent circuit.
[Fig. 25] Fig. 25 is a plan view illustrating wiring that connects the anodes and each light emitter in the light-emitting element.
[Fig. 26] Fig. 26 is a schematic diagram illustrating the area of contact of a p-electrode and the depth of a separation groove in the light emitter.
[Fig. 27] Fig. 27 is a schematic view illustrating a thickness of a surface coating layer on a light exiting surface of the light emitter.
[Fig. 28] Fig. 28 is a graph illustrating a relationship between current and light output that is caused due to the thickness of the surface coating layer.
[Fig. 29] Fig. 29 is a schematic diagram illustrating a position of a boundary between regions of surface coating layers on the light exiting surface of the light emitter.
[Fig. 30] Fig. 30 is a schematic view illustrating the position of the boundary between the regions of the surface coating layers on the light exiting surface of the light emitter.
[Fig. 31] Fig. 31 is a graph illustrating a distribution of a light-emission intensity of the light-emitting element (cos⁻¹θ: curved).
[Fig. 32] Fig. 32 is a graph illustrating the distribution of a light-emission intensity of the light-emitting element (cos⁻³θ: curved).
[Fig. 33] Fig. 33 is a graph illustrating the distribution of a light-emission intensity of the light-emitting element (cos⁻⁵θ: curved).
[Fig. 34] Fig. 34 is a graph illustrating the distribution of a light-emission intensity of the light-emitting element (cos⁻⁷θ: curved).
[Fig. 35] Fig. 35 is a graph illustrating the distribution of a light-emission intensity of the light-emitting element (cos⁻¹θ: step shape).
[Fig. 36] Fig. 36 is a graph illustrating the distribution of a light-emission intensity of the light-emitting element (cos⁻³θ: step shape).
[Fig. 37] Fig. 37 is a graph illustrating the distribution of a light-emission intensity of the light-emitting element (cos⁻⁵θ: step shape).
[Fig. 38] Fig. 38 is a graph illustrating the distribution of a light-emission intensity of the light-emitting element (cos⁻⁷θ: step shape).

### Mode(s) for Carrying Out the Invention

A ranging apparatus according to embodiments of the present technology is described.

### [Configuration of Ranging Apparatus]

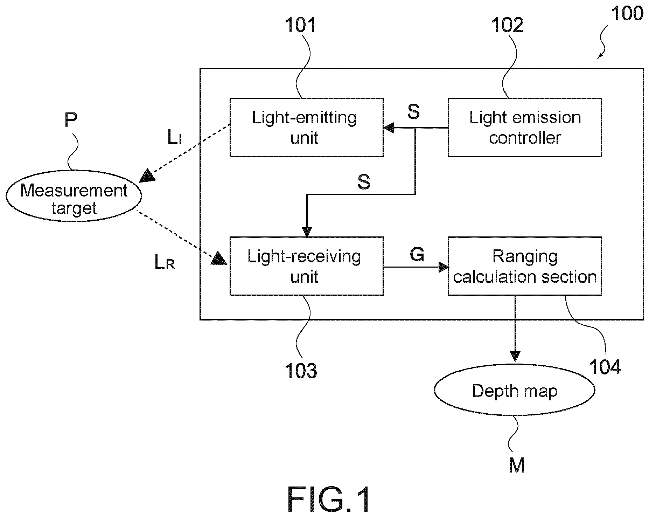

Fig. 1 is a block diagram illustrating a configuration of a ranging apparatus 100 according to the present embodiment. As illustrated in the figure, the ranging apparatus 100 includes a light-emitting unit 101, a light emission controller 102, a light-receiving unit 103, and a ranging calculation section 104.

The light-emitting unit 101 irradiates a measurement target P with irradiation light L_{I} of which the brightness is periodically changed. When a light-emission control signal S is supplied by the light emission controller 102, the light-emitting unit 101 generates the irradiation light L_{I} in synchronization with the light-emission control signal S. The configuration of the light-emitting unit 101 will be described later.

The light emission controller 102 controls a light emission of the light-emitting unit 101. The light emission controller 102 generates a light-emission control signal S, and supplies the generated light-emission control signal S to the light-emitting unit 101 and the light-receiving unit 103. The light-emission control signal S may be, for example, a square wave of a frequency of 100 MHz.

The light-receiving unit 103 receives reflected light L_{R} that is the light L_{I} reflected off the measurement target P, and detects an amount of light received. The light-receiving unit 103 receives a vertical synchronization signal, and can detect the amount of light received in a period of the vertical synchronization signal every time the period elapses. The vertical synchronization signal is, for example, a periodic signal of 60 Hz. The light-receiving unit 103 includes light-receiving elements arranged in a two-dimensional grid, and supplies the ranging calculation section 104 with image data G that corresponds to an amount of light received by each light-receiving element.

The ranging calculation section 10 calculates a distance from the light-receiving unit 103 to the measurement target P on the basis of the image data G supplied by the light-receiving unit 103. The ranging calculation section 104 can generate a depth map M in which a distance between each light-receiving element and the measurement target P is represented by a gradation value.

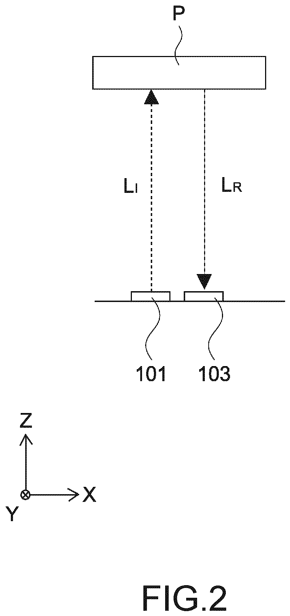

Fig. 2 is a schematic diagram illustrating a positional relationship between the light-emitting unit 101, the light-receiving unit 103, and the measurement target P. As illustrated in the figure, the light-emitting unit 101 and the light-receiving unit 103 are adjacently arranged, and a distance between the light-emitting unit 101 and the light-receiving unit 103 is, for example, about a few millimeters. A distance between each of the light-emitting unit 101 and the light-receiving unit 103, and the measurement target P may be from about several tens of centimeters to about a few meters. As described later, the light-emitting unit 101 according to the present embodiment can irradiate the irradiation light L_{I} for a long distance, and this enables a long-distance measurement.

Hereinafter, a Z direction represents a direction of an optical axis corresponding to the irradiation light L_{I}, and an X direction and a Y direction represent directions that are orthogonal to the Z direction and orthogonal to each other, as illustrated in Fig. 2.

### [Configuration of Light-Emitting Unit]

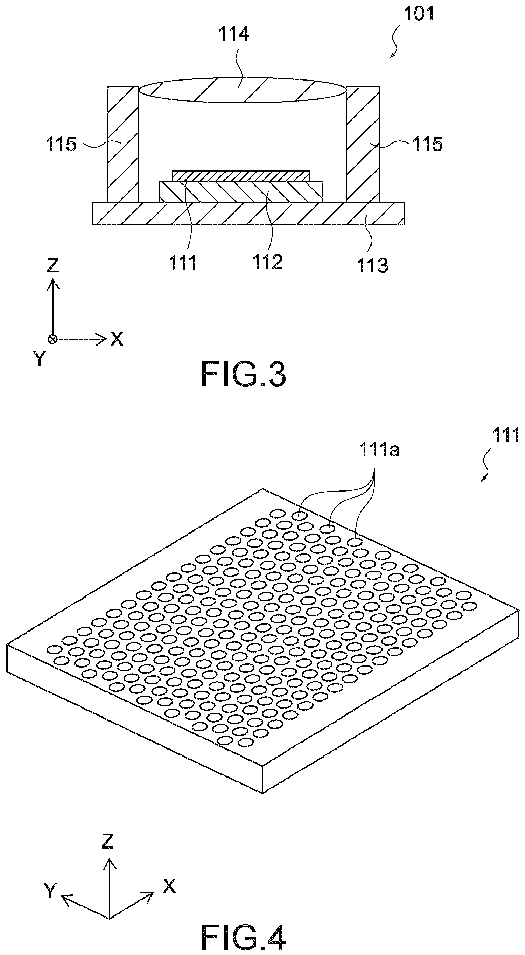

Fig. 3 is a schematic diagram illustrating a configuration of the light-emitting unit 101. As illustrated in the figure, the light-emitting unit 101 includes a light-emitting element 111, a light-emitting-element support 112, a base 113, a collimator lens 114, and a lens support 115.

The light-emitting element 111 includes a plurality of light emitters. Fig. 4 is a perspective view of the light-emitting element 111. As illustrated in the figure, the light-emitting element 111 includes a plurality of light emitters 111a two-dimensionally arranged in a direction (X-Y direction) orthogonal to the optical-axis direction (Z direction). Further, the light emitters 111a may be arranged in a line in parallel with a direction in an X-Y plane, that is, the light emitters 111a may be one-dimensionally arranged.

The light-emitting element 111 is fixed to the base 113 through the light-emitting-element support 112, as illustrated in Fig. 3. The collimator lens 114 is supported by the lens support 115, and collimates the exiting light L_{I} (forms the exiting light L_{I} into parallel light).

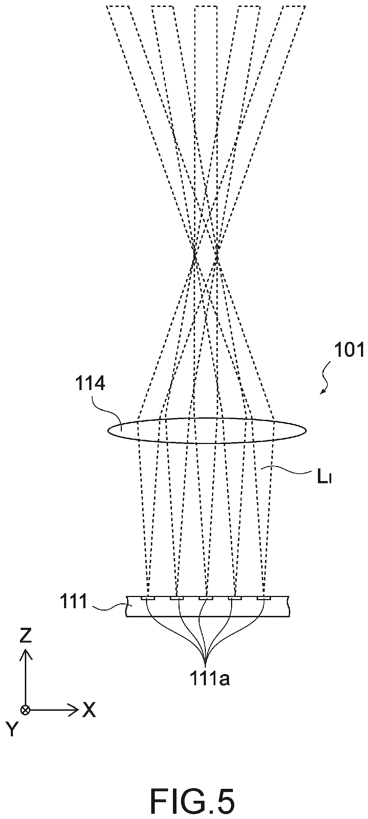

Fig. 5 is a schematic diagram illustrating the irradiation light L_{I} exiting the light-emitting unit 101. The irradiation light L_{I} exits each light emitter 111a, and then is collimated by the collimator lens 114 to be formed into a beam, as illustrated in the figure. The formation of the irradiation light L_{I} into a beam enables the irradiation light L_{I} to reach far. Further, the orientation of a light beam passing through a peripheral portion of the collimator lens 114 is tilted by the light beam passing through the collimator lens 114. This makes it possible to perform irradiation onto a wider range.

Note that the configuration of the light-emitting unit 101 is not limited thereto. For example, a diffraction grating (a diffractive optical element: DOE) may be arranged ahead of the collimator lens 114 to diffract the irradiation light L_{I} for tiling. This makes it possible to increase the number of irradiation spots, and to further make the irradiation range wider.

### [Configuration of Light-Emitting Element]

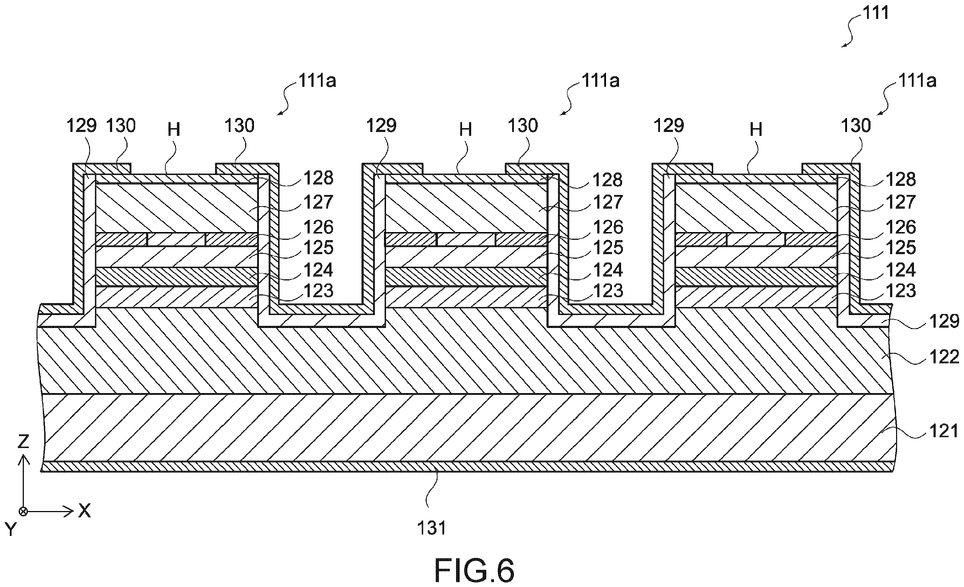

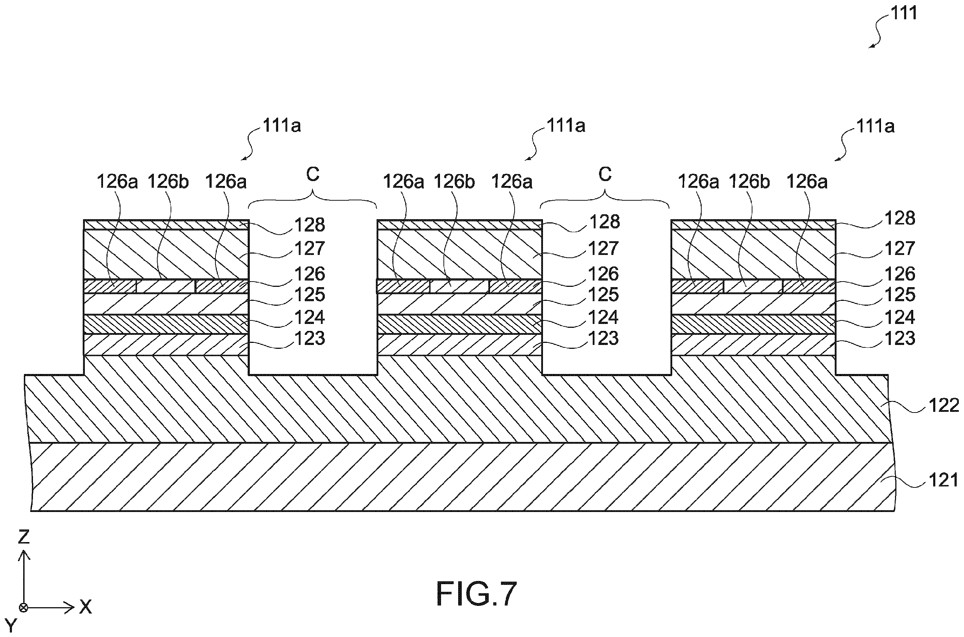

Each of the plurality of light emitters 111a included in the light-emitting element 111 is a vertical-cavity surface-emitting laser (VCSEL) element. Fig. 6 is a cross-sectional view of a portion of the light-emitting element 111, and illustrates three light emitters 111a. Fig. 7 is a cross-sectional view of the three light emitters 111a, and an illustration of a portion of a configuration of the light-emitting element 111 is omitted.

As illustrated in Figs. 6 and 7, the light-emitting element 111 includes a substrate 121, an n-DBR layer 122, an n-cladding layer 123, an active layer 124, a p-cladding layer 125, a current confinement layer 126, a p-DBR layer 127, a contact layer 128, an insulation layer 129, a p-electrode 130, and an n-electrode 131.

The substrate 121 supports each layer of the light-emitting element 111. The substrate 121 may be, for example, an n-Gas substrate, or may be made of another material.

The n-DBR layer 122 is provided on the substrate 121, and serves as a distributed Bragg reflector (DBR) off which light of a wavelength λ is reflected. The n-DBR layers 122 forms a resonator for lasing together with the p-DBR layer 127.

The n-DBR layer 122 may be formed by alternately stacking a low-refractive-index layer and a high-refractive-index layer multiple times. The low-refractive-index layer is made of, for example, n-type Alₓ₁Ga_{1-X1}As (0<X1<1), and the high-refractive-index layer is made of, for example, n-type Alₓ₂Ga₁₋ₓ₂As (0<X2<X1).

The n-cladding layer 123 is stacked on the n-DBR layer 122, and is a layer that confines light and current in the active layer 124. The n-cladding layer 123 is made of, for example, n-type Alₓ₃Ga₁₋ₓ₃As (0<X3<1).

The active layer 124 is provided on the n-cladding layer 123, and emits spontaneous-emission light and amplifies the spontaneous-emission light. The active layer 124 is made of, for example, undoped In_{X4}Ga_{1-X4}As or Alₓ₄Ga₁₋ₓ₄As (0<X4<1).

The p-cladding layer 125 is provided on the active layer 124, and is a layer that confines light and current in the active layer 124. The p-cladding layer 125 is made of, for example, p-type Alₓ₅Ga₁₋ₓ₅As (0<X5<1).

The current confinement layer 126 is provided on the p-cladding layer 125, and has a confinement effect on current. As illustrated in Fig. 7, the current confinement layer 126 has a confinement region 126a and an injection region 126b. The confinement region 126a is made of, for example, oxidized AlAs, and has a low conductivity and a low refractive index. The confinement region 126a serves as a light confining region. The injection region 126b is made of, for example, an unoxidized AlAs, and is a region having a higher conductivity than the confinement region 126a.

The p-DBR layer 127 is provided on the current confinement layer 126, and serves as a DBR off which light of a wavelength λ is reflected. The p-DBR layers 127 forms a resonator for lasing together with the n-DBR layers 122.

The p-DBR layer 127 may be formed by alternately stacking a low-refractive-index layer and a high-refractive-index layer multiple times. The low-refractive-index layer is made of, for example, p-type Alₓ₁Ga_{1-X6}As (0<X6<1), and the high-refractive-index layer is made of, for example, p-type Alₓ₇Ga₁₋ₓ₇As (0<X7<X6).

The contact layer 128 is provided on the p-DBR layer 127, and is a layer to which the p-electrode 131 is joined. The contact layer 128 is made of, for example, p-type GaAs or p-type Alₓ₈Ga₁₋ₓ₈As (0<X8<1) .

As illustrated in Fig. 7, the light emitter 111a includes a portion of the n-DBR layer 122, the n-cladding layer 123, the active layer 124, the p-cladding layer 125, the current confinement layer 126, the p-DBR layer 127, and the contact layer 128, and is spaced from an adjacent light emitter 111a using a separation groove C. The light emitter 111a has a mesa (flat-topped shape) structure.

The insulation layer 129 is formed on an inner peripheral surface of the separation groove C, as illustrated in Fig. 6, and insulates the adjacent light emitters 111a. The insulation layer 129 is made of, for example, SiO₂.

The p-electrode 130 is formed on the contact layer 128 and the insulation layer 129, and serves as a p-electrode of each light emitter 111a. The p-electrode 130 is made of any conductive material.

The n-electrode 131 is formed on the substrate 121, and serves as an n-electrode of each light emitter 111a. The n-electrode 131 is made of any conductive material.

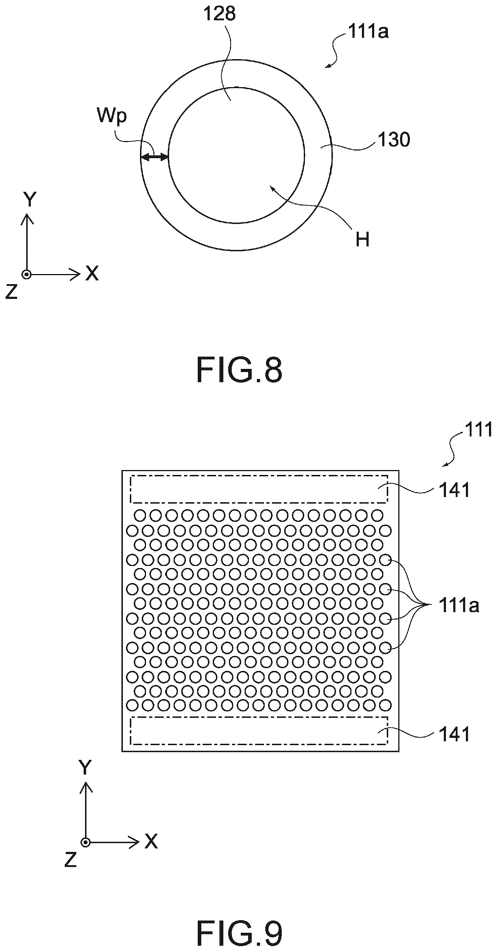

Fig. 8 illustrates one light emitter 111a, as viewed from a light exiting direction (Z direction). As illustrated in the figure, a peripheral portion of the surface of the contact layer 128 is covered with the p-electrode 130. A central portion of the surface of the contact layer 128 is not covered with the p-electrode 130, and is a surface from which laser light generated by the light emitter 111a exits. As illustrated in Figs. 6 and 8, this surface is hereinafter referred to as a "light exiting surface H". Note that a surface coating layer used to control optical characteristics may be provided to the light exiting surface H, as described later.

Fig. 9 is a plan view of a front surface of the light-emitting element 111. As illustrated in the figure, an anode 141 is provided as a "first electrode terminal" at each of two ends of the front surface of the light-emitting element 111. The anode 141 is a portion to which a drive source of the light-emitting element 111 is connected by, for example, wire bonding, and the p-electrode 130 included in each light emitter 111a is connected to the anode 141. The configuration of the anode 141 is not limited to the configuration illustrated in Fig. 9, and any configuration that makes it possible to electrically connect the drive source and the p-electrode 130 may be adopted.

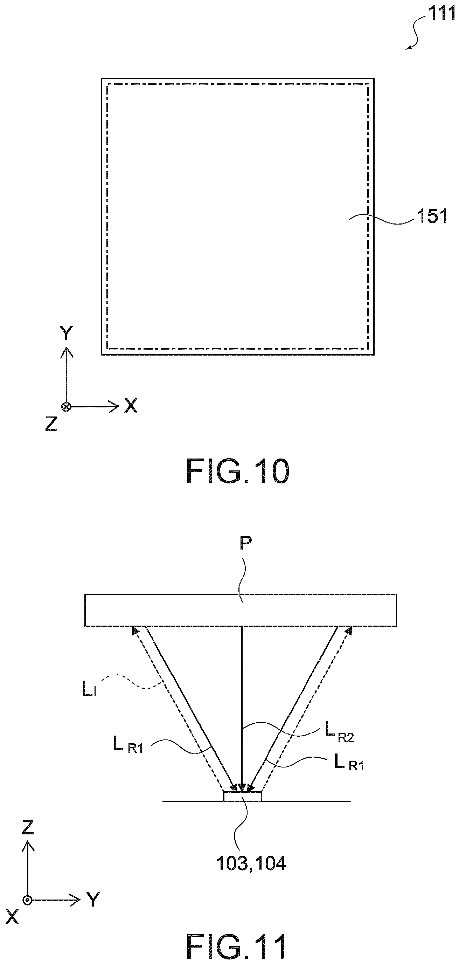

Fig. 10 is a plan view of a back surface of the light-emitting element 111. As illustrated in the figure, a cathode 151 is provided as a "second electrode terminal" on the back surface of the light-emitting element 111. The cathode 151 is a portion to which ground wiring of the light-emitting element 111 is connected by solder connection or using a conductive paste, and the n-electrode 131 included in each light emitter 111a is connected to the cathode 151. The configuration of the cathode 151 is not limited to the configuration illustrated in Fig. 10, and any configuration that makes it possible to electrically connect the ground of the light-emitting element 111 and the n-electrode 131 may be adopted.

The light-emitting element 111 has the configuration described above. Note that the configuration of the light-emitting element 111 is not limited thereto, and any configuration in which each light emitter 111a serves as a VCSEL may be adopted. For example, the light-emitting element 111 may be a VCSEL in which the light-emitting direction is a direction of the substrate, that is, a so-called back exit VCSEL.

### [Operation of Light-Emitting Element]

When voltage is applied between the anode 141 and the cathode 151, current flows through each light emitter 111a from the p-electrode 130 to the n-electrode 131. Due to a confinement effect of the current confinement layer 126, the current is injected through the injection region 126b.

Due to the injected current, spontaneous-emission light is generated in a region, in the active layer 124, that is adjacent to the injection region 126b. The spontaneous-emission light travels in a stacking direction of the light-emitting element 111 (Z direction), and is reflected off the n-DBR layer 122 and the p-DBR layer 127.

The n-DBR layer 122 and the p-DBR layer 127 are configured such that light of an oscillation wavelength λ is reflected off the n-DBR layer 122 and the p-DBR layer 127. From among the spontaneous-emission light, a component of the oscillation wavelength λ forms a standing wave between the n-DBR layer 122 and the p-DBR layer 127, and is amplified by the active layer 124.

When a value of the injected current exceeds a threshold, light forming a standing wave is lased, and is transmitted through the p-cladding layer 125, the current confinement layer 126, the p-DBR layer 127, and the contact layer 128 to exit from the light exiting surface H. Consequently, light corresponding to an optical axis of which a direction is the Z-axis direction exits each light emitter 111a, and light L_{I} corresponding to an optical axis of which a direction is the Z-axis direction exits the light-emitting unit 101 (refer to Fig. 5).

### [Regarding Distribution of Light-Emission Intensity]

In the ranging apparatus 100, the irradiation light L_{I} exits the light-emitting unit 101, and the light-receiving unit 103 receives the reflected light L_{R} reflected off the measurement target P to measure a distance to the measurement target P, as described above. Fig. 11 is a schematic diagram illustrating an angle of incidence of the reflected light L_{R}.

The light-emitting element 111 according to the present embodiment is configured such that the intensities of the pieces of irradiation light L_{I} emitted by the respective light emitters 111a (hereinafter referred to as light-emission intensities) are not uniform, and the pieces of irradiation light L_{I} have a specified distribution of a light-emission intensity. If the respective light emitters 111a have a uniform light-emission intensity, irradiation spots formed by the collimator lens 114 will also have a uniform brightness.

Here, the light-receiving unit 103 has the property of having a higher light-receiving sensitivity for light that enters from a wide angle of field (reflected light L_{R1} in Fig. 11) than for light that enters from a narrow angle of field (reflected light L_{R2} in Fig. 11). Thus, when irradiation spots have a uniform brightness, there may be a reduction in the accuracy in ranging performed with respect to a surrounding region in a measurement-target range.

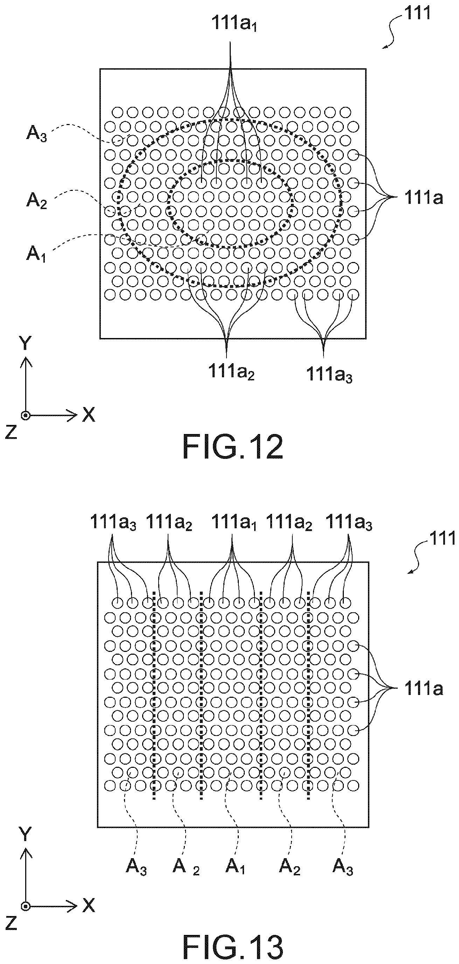

Fig. 12 is a plan view of the light-emitting element 111 according to the present embodiment, as viewed from a direction (Z direction) extending in parallel with an optical axis corresponding to exiting light. As illustrated in the figure, the front surface of the light-emitting element 111 is divided into a plurality of regions referred to as a first region A₁, a second region A₂, and a third region A₃.

The first region A₁ includes the light emitter 111a situated in an inner portion of a plurality of light emitters 111a, and is a region situated in a central portion of the light-emitting element 111. The third region A₃ includes the light emitter 111a in an outer portion of the plurality of light emitters 111a, and is a region situated in a surrounding portion of the light-emitting element 111. The second region A₂ is a region between the first region A₁ and the third region A₃, and includes the light emitter 111a situated between the first region A₁ and the third region A₃.

The light-emitting element 111 is configured such that the third region A₃ exhibits a highest light-emission intensity, the second region A₂ exhibits a second highest light-emission intensity, and the first region A₁ exhibits a lowest light-emission intensity, as described later. This makes it possible to compensate for a reduction in the light-receiving sensitivity for light that enters the light-receiving unit 103 from a wide angle of field (the reflected light L_{R1} in Fig. 11) and to prevent a reduction in the accuracy in ranging performed with respect to a surrounding region in a measurement-target range.

In Fig. 12, the first region A₁ to the third region A₃ are distributed in two directions that are the X-direction and the Y-direction, that is, in a two-dimensional manner. However, the first region A₁ to the third region A₃ may be distributed only in the X-direction, that is, in a one-dimensional manner.

Fig. 13 is a plan view of the one-dimensionally distributed first to third regions A₁ to A₃. As illustrated in the figure, the first region A₁ may be a region situated in a central portion of the light-emitting element 111, the third region A₃ may be a region situated in a surrounding portion of the light-emitting element 111, and the second region A₂ may be a region situated between the first region A₁ and the third region A₃.

Note that, in the following description, the light emitter 111a included in the first region A₁ is referred to as a first light emitter 111a₁, the light emitter 111a included in the second region A₂ is referred to as a second light emitter 111a₂, and the light emitter 111a included in the third region A₃ is referred to as a third light emitter 111a₃. The number of first light emitters 111a₁, the number of second light emitters 111a₂, and the number of third light emitters 111a₃ are not particularly limited.

The light-emitting element 111 has the following configuration in order to make a difference in the light-emission intensity of the light emitter 111a between the first region A₁, the second region A₂, and the third region A₃. Note that the number of regions into which the light-emitting element 111 is divided is not limited to the example described above.

### <1. Difference in Light-Emission Intensity Depending on Electrical Resistance>

As described above, each light emitter 111a is electrically connected to the anode 141 and the cathode 151, and a current path from the anode 141 to the cathode 151 that passes through each light emitter 111a is formed between the anode 141 and the cathode 151.

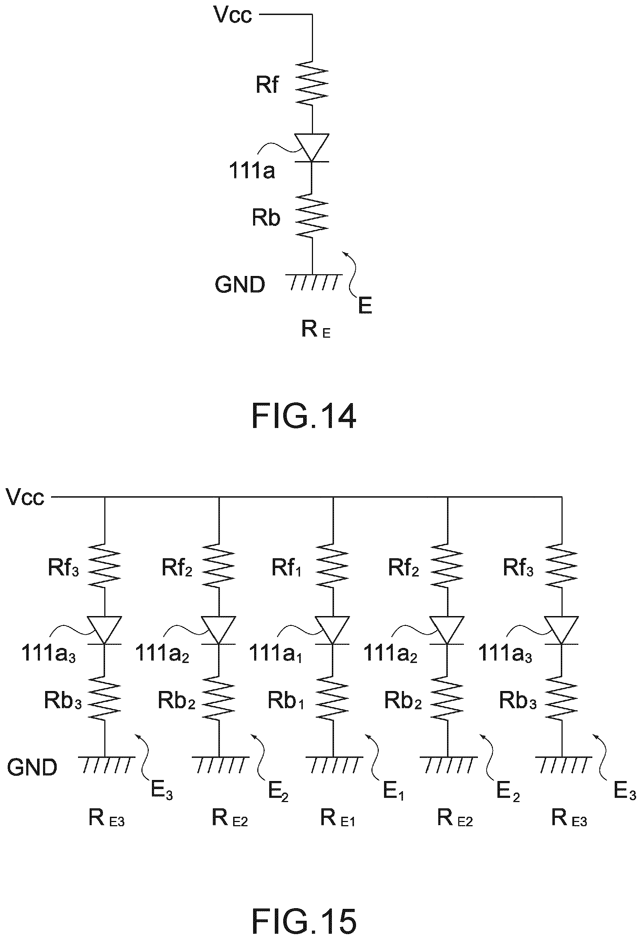

Fig. 14 is a circuit diagram illustrating an equivalent circuit of a current path in one light emitter 111a. In the figure, Vcc (a power-supply potential) is a potential of the anode 141, and GND (a ground potential) is a potential of the cathode 151. A resistance Rf is a resistance between the light emitter 111a and the anode 141, and a resistance Rb is a resistance between the light emitter 111a and the cathode 151. As illustrated in the figure, a current path from the anode 141 to the cathode 151 that passes through the light emitter 111a is referred to as a current path E, and a resistance of the current path E is referred to as a path resistance R_{E}.

Fig. 15 is a circuit diagram illustrating an equivalent circuit of current paths of the first light emitter 111a₁, the second light emitter 111a₂, and the third light emitter 111a₃. As illustrated in the figure, a current path from the anode 141 to the cathode 151 that passes through the first light emitter 111a₁ is referred to as a first current path E₁. Likewise, a current path that passes through the second light emitter 111a₂ is referred to as a second current path E₂, and a current path that passes through the third light emitter 111a₃ is referred to as a third current path E₃.

As illustrated in Fig. 15, the resistance Rf in the first current path E₁ is referred to as a resistance Rf₁, the resistance Rf in the second current path E₂ is referred to as a resistance Rf₂, and the resistance Rf in the third current path E₃ is referred to as a resistance Rf₃. Further, the resistance Rb in the first current path E₁ is referred to as a resistance Rb₁, the resistance Rb in the second current path E₂ is referred to as a resistance Rb₂, and the resistance Rb in the third current path E₃ is referred to as a resistance Rb₃.

A resistance of the entirety of the first current path E₁ is obtained by summing the resistance Rf₁ and the resistance Rb₁, and a resistance of the entirety of the second current path E₂ is obtained by summing the resistance Rf₂ and the resistance Rb₂. A resistance of the entirety of the third current path E₃ is obtained by summing the resistance Rf₃ and the resistance Rb₃. Hereinafter, the resistance of the entirety of the first current path E₁ is referred to as a first path resistance R_{E1}, the resistance of the entirety of the second current path E₂ is referred to as a second path resistance R_{E2}, and the resistance of the entirety of the current path E₃ is referred to as a third path resistance R_{E3}.

A current path in a region, on the front surface of the light-emitting element 111, that is situated closer to the center of the front surface exhibits a higher resistance. In other words, the first path resistance R_{E1}, the second path resistance R_{E2}, and the third path resistance R_{E3} are different from each other, where the first path resistance R_{E1} is higher than the second path resistance R_{E2}, and the second path resistance R_{E2} is higher than the third path resistance R_{E3}.

A larger current flows through a current path exhibiting a lower path resistance R_{E}, and this results in the light emitter 111a exhibiting a higher light-emission intensity. Thus, the third light emitter 111a₃ exhibits a highest light-emission intensity, the second light emitter 111a₂ exhibits a second highest light-emission intensity, and the first light emitter 111a₁ exhibits a lowest light-emission intensity.

This makes it possible to compensate for a reduction in the light-receiving sensitivity for light (the reflected light L_{R1} in Fig. 11) that enters the light-receiving unit 103 from a wide angle of field, and to prevent a reduction in the accuracy in ranging performed with respect to a surrounding region in a measurement-target range.

A specific method for making a difference between the first path resistance R_{R1}, the second path resistance R_{E2}, and the third path resistance R_{E3} is described below.

### {1-1. Control of Path Resistance Performed Using OA Diameter}

In the light-emitting element 111, it is possible to make a difference in a resistance of a current path by controlling an internal resistance of each light emitter 111a using an aperture diameter (an optical aperture (OA) diameter) of the light emitter 111a.

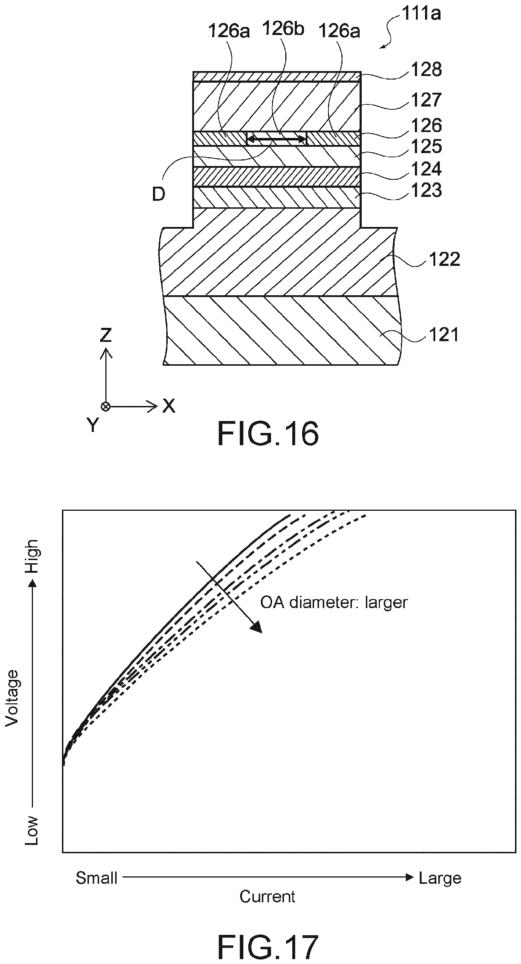

Fig. 16 is a cross-sectional view of a portion of the configuration of the light emitter 111a, and illustrates an OA diameter D. As illustrated in the figure, the OA diameter D is a diameter of the injection region 126b of the current confinement layer 126. In the light emitter 111a, current applied to the light emitter 111a is injected through the injection region 126b, and spontaneous-emission light is generated in a region, in the active layer 124, that is adjacent to the injection region 126b. In other words, the injection region 126b serves as an optical aperture.

Fig. 17 is a graph illustrating a relationship between voltage and current for each OA diameter of the light emitter 111a. As indicated by an arrow in the figure, voltage necessary to cause the same amount of current to flow is reduced as the OA diameter is increased.

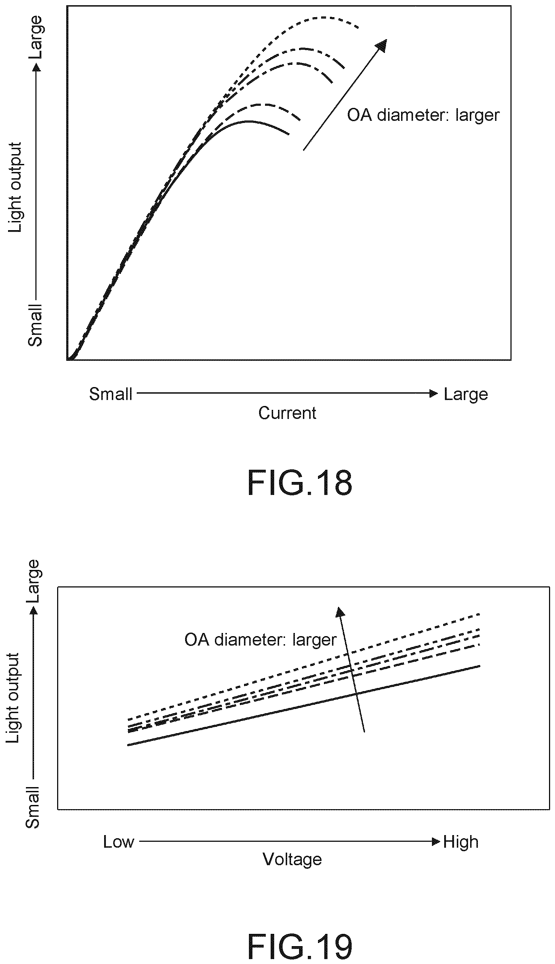

Fig. 18 is a graph illustrating a relationship between current and light output for each OA diameter of the light emitter 111a. As indicated by an arrow in the figure, a saturation light output is increased as the OA diameter is increased, but the light output remains unchanged with the same amount of current regardless of the OA diameter when the light output is smaller than the saturation light output.

Fig. 19 is a graph illustrating a relationship between voltage and light output for each OA diameter of the light emitter 111a. As indicated by an arrow in the figure, light output at the same voltage is increased as the OA diameter is increased.

Thus, in the light-emitting element 111, the OA diameter of the light emitter 111a differs between regions that are the first region A₁ to the third region A₃, and this makes it possible to control a level of difficulty in current flowing due to voltage, that is, a resistance of the light emitter 111a, and to make a difference in the path resistance R_{E}.

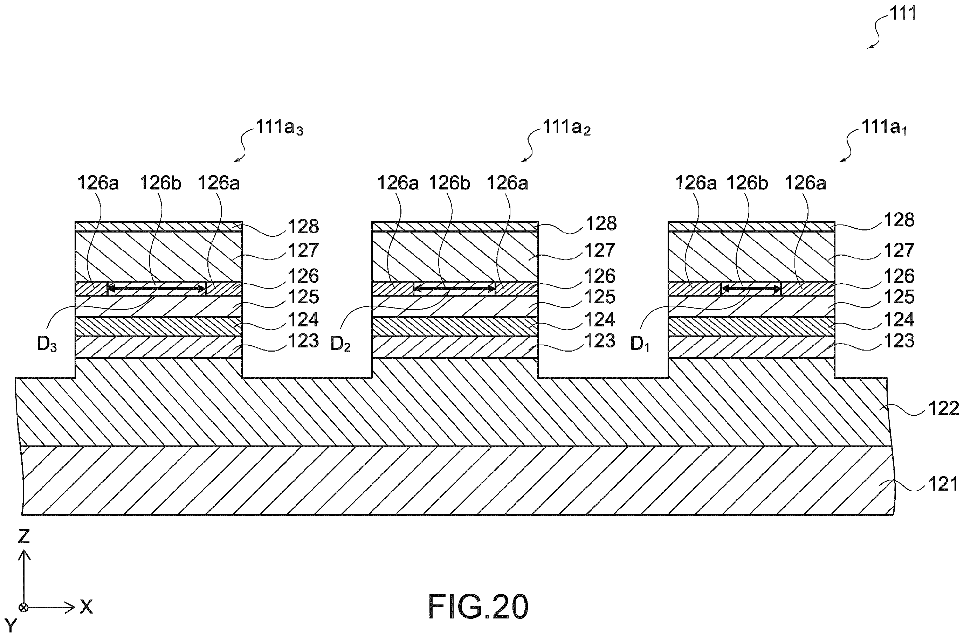

Specifically, the OA diameter of the third light emitter 111a₃ is made largest, the OA diameter of the second light emitter 111a₂ is made second largest, and the OA diameter of the first light emitter 111a₁ is made smallest. Fig. 20 a schematic diagram illustrating the OA diameters D of the first light emitter 111a₁ to the third light emitter 111a₃. As illustrated in the figure, an OA diameter D₃ of the third light emitter 111a₃ is larger than an OA diameter D₂ of the second light emitter 111a₂, and the OA diameter D₂ of the second light emitter 111a₂ is larger than an OA diameter D₁ of the first light emitter 111a₁. For example, the OA diameter D₃ may be 9 µm, the OA diameter D₂ may be 8 µm, and the OA diameter D₁ may be 7 µm.

Consequently, the first path resistance R_{E1} is highest, the second path resistance R_{E2} is second highest, and the third path resistance R_{E3} is lowest. Accordingly, the third light emitter 111a₃ exhibits a highest light-emission intensity, the second light emitter 111a₂ exhibits a second highest light-emission intensity, and the first light emitter 111a₁ exhibits a lowest light-emission intensity.

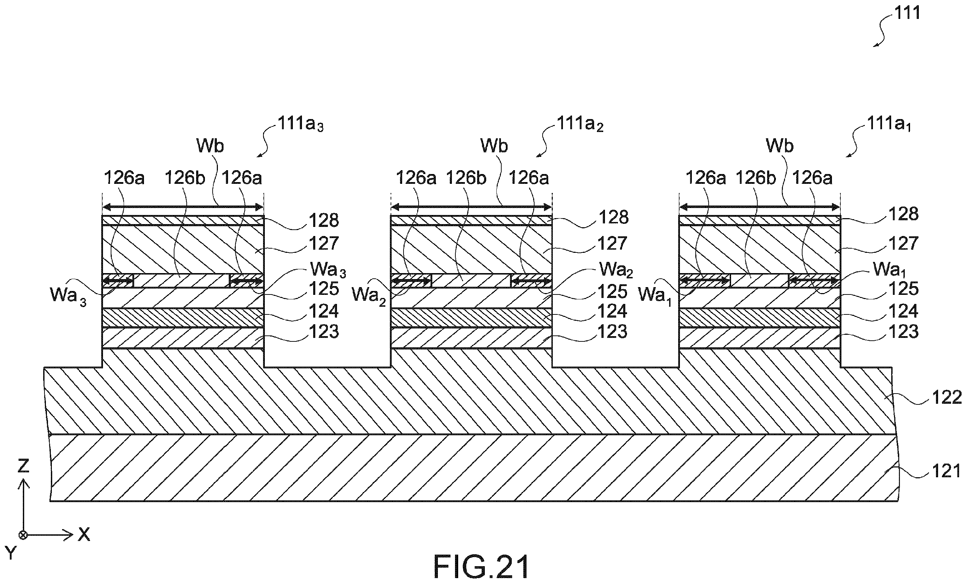

A method for changing the width of the confinement region 126a measuring from an outer periphery of the mesa structure is a method for making a difference in OA diameter between the light emitters 111a. Fig. 21 is a schematic diagram illustrating a difference in the width of the confinement region 126a. As illustrated in the figure, the width of the confinement region 126a of the first light emitter 111a₁ is referred to as a width Wai, the width of the confinement region 126a of the second light emitter 111a₂ is referred to as a width Wa₂, and the width of the confinement region 126a of the third light emitter 111a₃ is referred to as a width Wa₃.

Note that widths Wb of the mesa structures of the respective light emitters 111a are the same. Here, the OA diameter D₃ can be made largest and the OA diameter D₁ can be made smallest by making the width Wa₃ smaller than the width Wa₂ and by making the width Wa₂ smaller than the width Wa₁.

The confinement region 126a can be formed by performing an oxidation treatment after layers that form the current confinement layer 126 are stacked. In this case, it is possible to make a difference in the width of the confinement region 126a between the first region A₁ to the third region A₃ by adjusting the time for the oxidation treatment or another condition for the oxidation treatment.

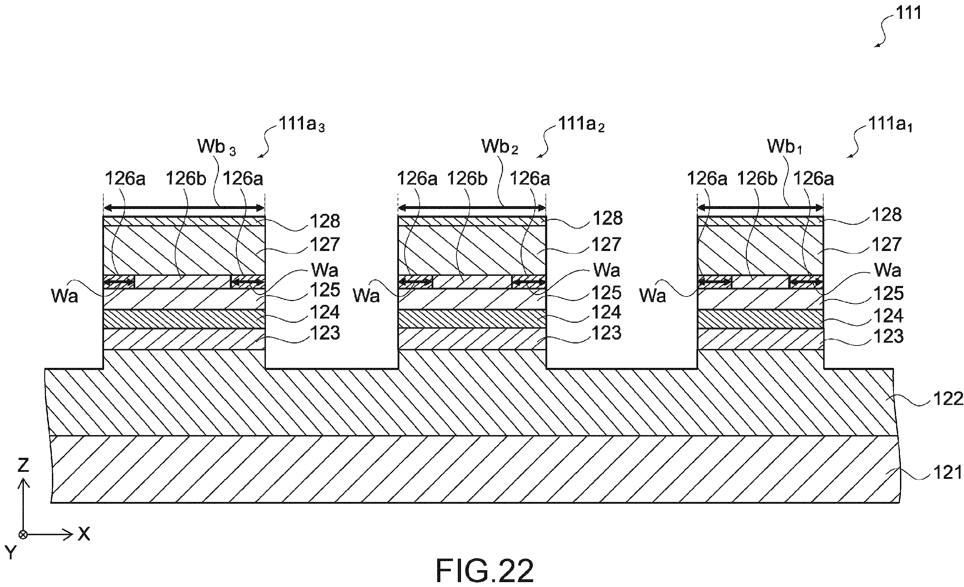

Further, a method for changing the diameter of the mesa structure (hereinafter referred to as a mesa diameter) is another method for making a difference in OA diameter between the light emitters 111a. Fig. 22 is a schematic diagram illustrating a difference in mesa diameter. As illustrated in the figure, the mesa diameter of the first light emitter 111a₁ is referred to as a diameter Wbi, the mesa diameter of the second light emitter 111a₂ is referred to as a diameter Wb₂, and the mesa diameter of the third light emitter 111a₃ is referred to as a diameter Wb₃.

Note that widths Wa of the confinement regions 126a of the respective light emitters 111a are the same. Here, the OA diameter D₃ can be made largest and the OA diameter D₁ can be made smallest by making the diameter Wb₃ larger than the diameter Wb₂ and by making the diameter Wb₂ larger than the diameter Wb₁.

The diameter of the mesa structure can be adjusted by the position at which the separation groove C (refer to Fig. 7) is formed or by the width of the separation groove C. This method makes it possible to change the OA diameter, with the widths Wa of the confinement regions 126a of the first region A₁ to the third region A₃ being the same. This makes it possible to adopt the same condition of oxidization treatment performed to form the confinement regions 126a of the first region A₁ and the third region A₃.

Further, it is also possible to make a difference in the OA diameter of the light emitter 111a between the first region A₁ to the third region A₃ by changing both the width Wa of the confinement region 126a and the mesa diameter Wb.

### {1-2. Control of Path Resistance Performed Using Wiring Resistance}

In the light-emitting element 111, for example, a wiring electrode structure in which electrodes are arranged in separate lines is adopted instead of the structure including electrodes that uniformly cover the entirety of the light-emitting element 111, in order to connect the anode 141 and the p-electrode 130 included in each light emitter 111a, and it is possible to make a difference between the first path resistance R_{R1}, the second path resistance R_{E2}, and the third path resistance R_{E3} using an electrical resistance of the wiring.

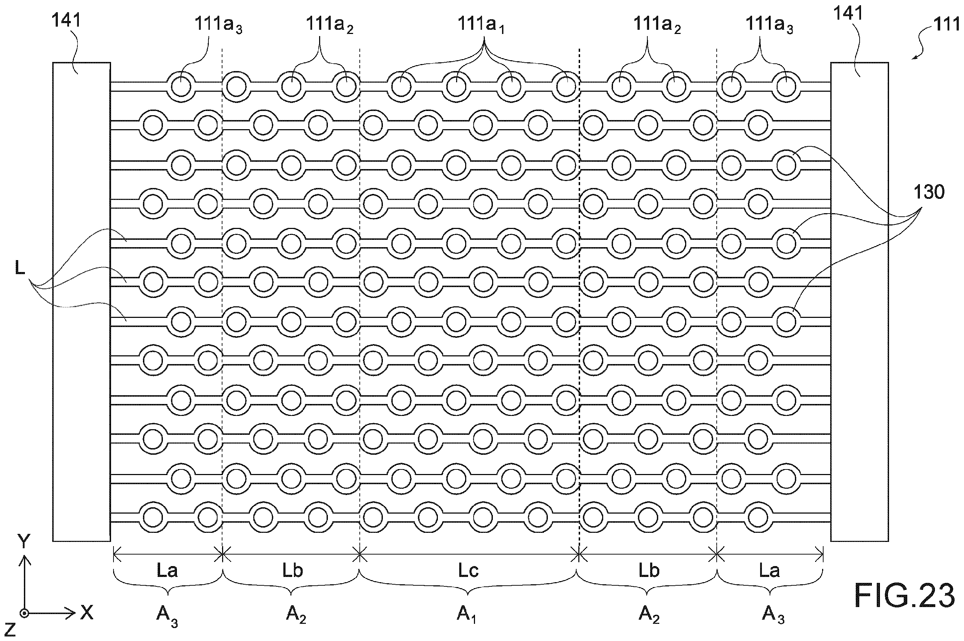

Fig. 23 is a schematic diagram illustrating wiring L that connects the light emitters 111a and the anodes 141 situated at two ends of the light-emitting element 111. As illustrated in the figure, the light emitters 111a are arranged in a plurality of lines in the X direction. A plurality of pieces of wiring L extends in the X direction from the anodes 141 situated at the two ends, and the light emitters 111a in each line are connected to the wiring L in series. Note that the wiring L may be the p-electrode 130 formed between the light emitters 111a in Fig. 6. However, the wiring L may be a conductive member different from the p-electrode 130.

In this configuration, the light-emission intensity of the third region A₃ can be made highest and the light-emission intensity of the first region A₁ can be made lowest when the first region A₁, the second region A₂, and the third region A₃ are one-dimensionally arranged, as illustrated in Fig. 13. In each piece of wiring L, the wiring L between the anode 141 and the second region A₂ is referred to as a wiring portion La, and the wiring L between the first region A₁ and the third region A₃ is referred to as a wiring portion Lb, as illustrated in Fig. 23. Further, the wiring L between the second regions A₂ is referred to as a wiring portion Lc.

The wiring L exhibits some resistance, although the wiring L is made of a conductive material. Hereinafter, the resistance of the wiring portion La is referred to as a resistance RLa, and the resistance of the wiring portion Lb is referred to as a resistance RLb.

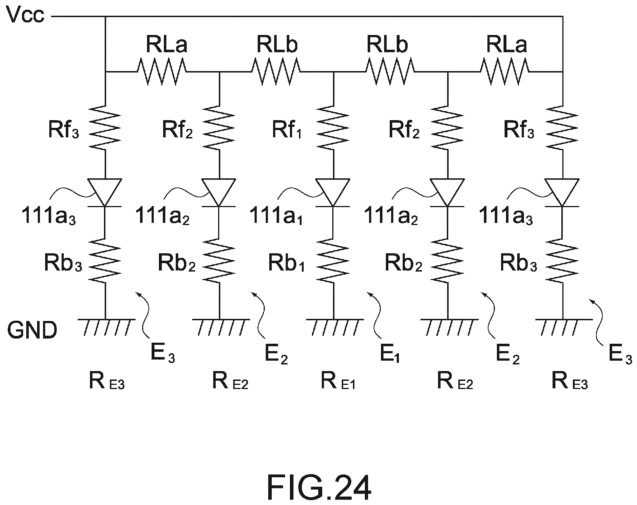

Fig. 24 is a circuit diagram of the light-emitting element 111. As illustrated in the figure, the third path resistance R_{E3} corresponding to the resistance of the third current path E₃ is obtained by summing the resistance Rf₃ and resistance Rb₃. On the other hand, the second path resistance R_{E2} corresponding to the resistance of the second current path E₂ is obtained by summing the resistance RLa, the resistance Rf₂, and the resistance Rb₂, since there is the wiring portion La in a current path between the anode 141 and the second light emitter 111a₂.

Further, the first path resistance R_{E1} corresponding to the resistance of the first current path E₁ is obtained by summing the resistance RLa, the resistance Rf₂, and the resistance Rb₂, since there are the wiring portion La and the wiring portion Lb in a current path between the anode 141 and the first light emitter 111a₁.

As described above, the wiring L between the anode 141 situated at each of the two ends and the third light emitter 111a₃ adjacent to the anode 141 is short, and the third path resistance R_{E3} is low. On the other hand, the wiring L (the wiring portion La) between the anode 141 situated at each of the two ends and the second light emitter 111a₂ situated away from the anode 141 is long, and the second path resistance R_{E2} is high.

Further, the wiring L (the wiring La + the wiring Lb) between the anode 141 situated at each of the two ends and the first light emitter 111a₁ situated farthest away from the anode 141 is longer, and the first path resistance R_{E1} is highest. As described above, it is possible to make a difference in the path resistance R_{E} between regions by making a difference between the first region A₁, the second region A₂, and the third region A₃ in the length of the wiring L situated between the anode 141 and the light emitter 111a.

Note that the wiring L does not necessarily have to have the same cross-sectional area. For example, the wiring portion La may have a larger cross-sectional area than the wiring portion Lb, and the wiring portion Lb may have a larger cross-sectional area than the wiring portion Lc. The cross-sectional area of the wiring L can be adjusted by changing at least one of a width or a thickness of the wiring L.

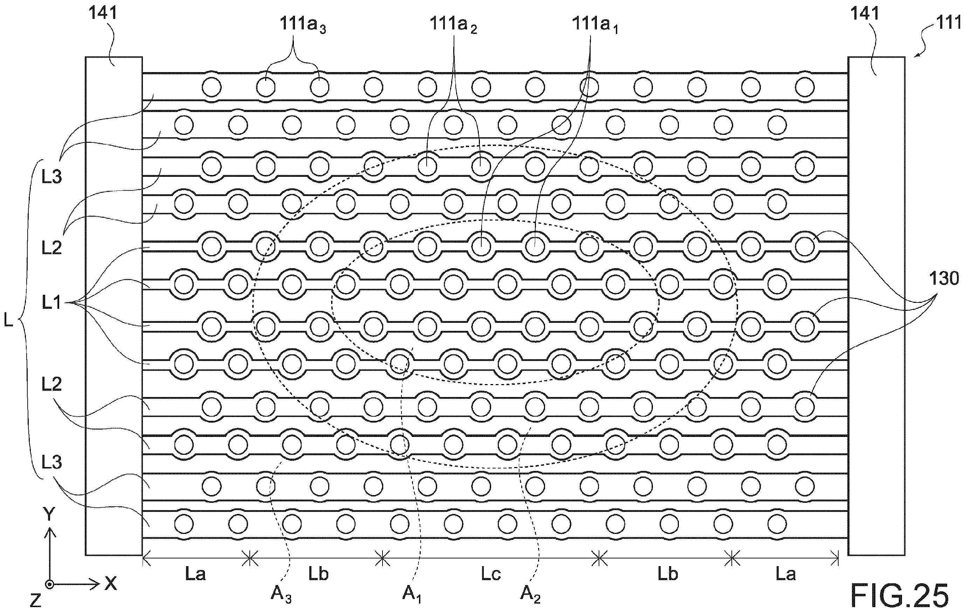

Further, in the light-emitting element 111, it is also possible to make the light-emission intensity of the third region A₃ highest and to make the light-emission intensity of the first region A₁ lowest when the first region A₁, the second region A₂, and the third region A₃ are two-dimensionally arranged, as illustrated in Fig. 12. Fig. 25 is a schematic diagram illustrating the wiring L connecting the light emitters 111a and the anodes 141 situated at two ends of the light-emitting element 111. As illustrated in the figure, the light emitters 111a are arranged in a plurality of lines in the X direction, and a plurality of pieces of wiring L extends in the X direction from the anodes 141 situated at the two ends. The light emitters 111a in each line are connected to the wiring L in series.

Here, the wiring L includes wiring L1, wiring L2, and wiring L3. The wiring L1 is wiring that passes through the third region A₃ and the second region A₂ to extend to the first region A₁, and the wiring L2 is wiring that passes through the third region A₃ to extend to the second region A₂. The wiring L3 is wiring that extends to the third region A₃. Note that the number of pieces of wiring L1, the number of pieces of wiring L2, and the number of pieces of wiring L3 may be set discretionarily, and are not limited to the numbers illustrated in Fig. 25.

The wiring L1, the wiring L2, and the wiring L3 exhibit different electrical resistances, where the wiring L3 exhibits a lowest electrical resistance, and the wiring L1 exhibits a highest electrical resistance. The electrical resistances of the wiring L1, the wiring L2, and the wiring L3 can be controlled by their cross-sectional areas, where the wiring L3 may have a larger cross-sectional area than the wiring L2, and the wiring L2 may have a larger cross-sectional area than the wiring L1.

The cross-sectional area of the wiring L can be adjusted by changing at least one of a width or a thickness of the wiring L. As illustrated in Fig. 25, the wiring L may have a uniform thickness, the wiring L3 may have a greater width than the wiring L2, and the wiring L2 may have a greater width than the wiring L1.

Further, the wiring L may have a uniform width, the wiring L3 may have a greater thickness than the wiring L2, and the wiring L2 may have a greater thickness than the wiring L1. Moreover, both the thickness and the width of the wiring L can be adjusted such that the wiring L3 has a larger cross-sectional area than the wiring L2, and the wiring L2 has a larger cross-sectional area than the wiring L1. Note that the wiring L is not limited to three types of wiring that are the wiring L1, the wiring L2, and the wiring L3 of different cross-sectional areas, and the wiring L may be two types of wiring, or four or more types of wiring.

In this configuration, in the X direction in which the wiring L extends, the path resistance R_{E} in the central portion is increased using the length of the wiring L connecting each light emitter 111a and the anode 141. Further, in the Y direction, the path resistance R_{E} in the central portion is increased using a difference in the electrical resistance of the wiring L. Thus, the first path resistance R_{E1} can be made highest, the second path resistance R_{E2} can be made second highest, and the third path resistance R_{E3} can be made lowest when the first region A₁, the second region A₂, and the third region A₃ are two-dimensionally arranged.

As described above, the light-emitting element 111 in which a surrounding region (the third region A₃) exhibits a higher light-emitting intensity than a central region (the first region A₁) can be provided by making a difference in the path resistance R_{E} between the first region A₁, the second region A₂, and the third region A₃ using a resistance of the wiring L. In this configuration, the respective light emitters 111a have the same configuration. Thus, it is possible to form a distribution of a light-emission intensity only by changing the wiring width, with conditions for producing the respective light emitters 111a being the same.

Note that Figs. 23 and 25 illustrate an example of providing the wiring L connecting a plurality of light emitters 111a. However, a planar electrode (a solid-pattern electrode) may be provided instead of the wiring L. In this case, it is possible to make a difference in path resistance by the wiring resistances from the anode 141 to the respective light emitters 111a being different.

### {1-3. Control of Path Resistance Performed Using Contact Resistance}

Further, in the light-emitting element 111, it is also possible to make a difference in the path resistance R_{E} using a contact resistance in each light emitter 111a, that is, a resistance between a semiconductor and a metal interface.

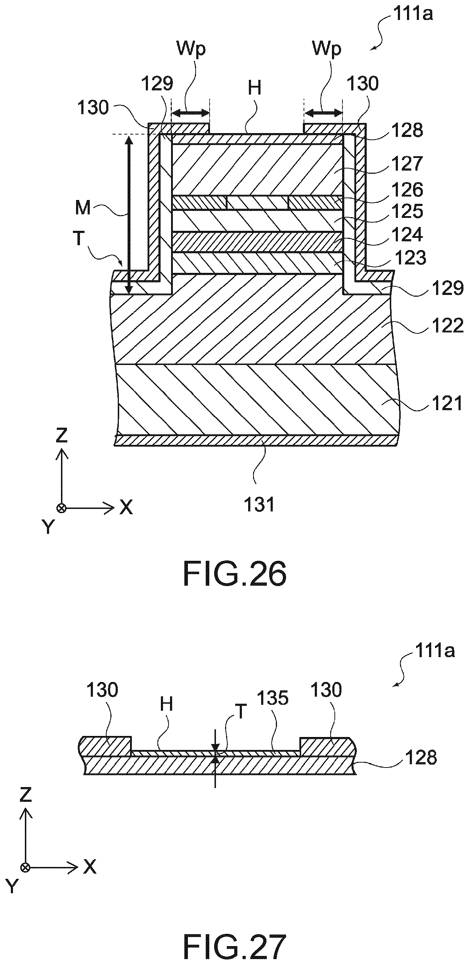

Fig. 26 is a cross-sectional view of the light emitter 111a. The area of contact of the p-electrode 130 with the contact layer 128 can be changed by adjusting a width Wp of the p-electrode 130 in contact with the contact layer 128, as illustrated in Figs. 26 and 8. This makes it possible to increase or decrease the resistance Rf (refer to Fig. 14) in the light emitter 111a, and to make a difference between the first path resistance R_{R1}, the second path resistance R_{E2}, and the third path resistance R_{E3}.

Specifically, the width Wp in the third light emitter 111a₃ may be set to be a specified width to set the resistance Rf₃ (refer to Fig. 15). Further, the width Wp in the second light emitter 111a₂ may be smaller than the width Wp in the third light emitter 111a₃ such that the resistance Rf₂ exhibits a larger value than the resistance Rf₃. Furthermore, the width Wp in the first light emitter 111a₁ may be smaller than the width Wp in the second light emitter 111a₂ such that the resistance Rf₁ exhibits a larger value than the resistance Rf₂.

Further, the resistance Rf can also be increased or decreased by changing the shape of the p-electrode 130 and adjusting the area of contact of the p-electrode 130 with the contact layer 128, in addition to controlling the width Wp.

Furthermore, the resistance Rb (refer to Fig. 14) can be increased or decreased by adjusting a depth M of the separation groove C (refer to Fig. 7), as illustrated in Fig. 26, and this makes it possible to make a difference between the first path resistance R_{R1}, the second path resistance R_{E2}, and the third path resistance R_{E3}.

Specifically, the depth M of the separation groove C situated around the third light emitter 111a₃ may be set to be a specified depth to set the resistance Rb₃ (refer to Fig. 15). Further, the depth M of the separation groove C situated around the second light emitter 111a₂ may be greater than the depth M of the separation groove C situated around the third light emitter 111a₃ such that the resistance Rb₂ exhibits a larger value than the resistance Rb₃. Furthermore, the depth M of the separation groove C situated around the first light emitter 111a₁ may be greater than the depth M of the separation groove C situated around the second light emitter 111a₂ such that the resistance Rb₁ exhibits a larger value than the resistance Rb₂.

Further, both the widths Wp and the depths M of the first light emitter 111a₁, the second light emitter 111a₂, and the third light emitter 111a₃ can also be changed such that the first path resistance R_{R1} is highest and the third path resistance R_{E3} is lowest.

The above-described adjustment of the width Wp and the depth M makes it possible to make a difference in the path resistance R_{E} between the first region A₁, the second region A₂, and the third region A₃. Such a configuration also makes it possible to form a distribution of a light-emission intensity only using the shape of the p-electrode 130 or the depth of the separation groove C, with the respective light emitters 111a having a uniform stacking structure.

As described above, the light-emitting element 111 in which the surrounding region (the third region A₃) exhibits a higher light-emitting intensity than the central region (the first region A₁) can be provided using a difference in the path resistance R_{E} between the first region A₁, the second region A₂, and the third region A₃.

Note that, with respect to the method for making a difference in the path resistance R_{E} between the first path resistance R_{R1}, the second path resistance R_{E2}, and the third path resistance R_{E3}, only one of the control performed using an OA diameter, the control performed using a wiring resistance, and the control performed using a contact resistance described above may be used, or two or more thereof may be used in combination. For example, a one-dimensional distribution of a light-emission intensity (refer to Fig. 13) can be formed by performing the control by a wiring resistance, and then a two-dimensional distribution of a light-emission intensity (refer to Fig. 12) can be formed by performing the control by an OA diameter.

Further, the light-emitting element 111 in which the first path resistance R_{R1} is highest, the second path resistance R_{E2} is second highest, and the third path resistance R_{E3} is lowest can also be provided by a method, such as changing a material of the wiring L, that is different from the respective methods described above.

### <2. Difference in Light-Emission Intensity Due to Light Extraction Efficiency>

In the light-emitting element 111, it is possible to make a difference in light-emission intensity between the first region A₁, the second region A₂, and the third region A₃ (refer to Figs. 12 and 13) by controlling the light extraction efficiency of the light emitter 111a. Note that, when a difference in light-emission intensity is made due to the light extraction efficiency of the light emitter 111a, the above-described path resistances of the light emitters 111a may be the same.

Specifically, in the light-emitting element 111, the light extraction efficiencies of the light emitters 111a in the first region A₁, the second region A₂, and the third region A₃ are different from each other, and the light emitter 111a has a higher light extraction efficiency in a region, on the front surface of the light-emitting element 111, that is situated closer to the center of the front surface. In other words, the third light emitter 111a₃ has a highest light extraction efficiency, the second light emitter 111a₂ included in the second region A₂ has a second highest light extraction efficiency, and the first light emitter 111a₁ has a lowest light extraction efficiency. Consequently, the third region A₃ exhibits a highest light-emission intensity, the second region A₂ exhibits a second highest light-emission intensity, and the first region A₁ exhibits a lowest light-emission intensity.

This makes it possible to compensate for a reduction in the light-receiving sensitivity for light (the reflected light L_{R1} in Fig. 11) that enters the light-receiving unit 103 from a wide angle of field, and to prevent a reduction in the accuracy in ranging performed with respect to a surrounding region in a measurement-target range, as described above.

A specific structure that makes a difference in the light extraction efficiency of the light emitter 111a is described below.

### {2-1. Control of Light Extraction Efficiency Performed Using Thickness of Surface Coating Layer}

In the light-emitting element 111, it is possible to make a difference in the light extraction efficiency of the light emitter 111a using a thickness of a surface coating layer included in each light emitter 111a.

Fig. 27 is an enlarged cross-sectional view of the light emitter 111a, and illustrates a surface coating layer 135 that is included in the light emitter 111a. As illustrated in the figure, the surface coating layer 135 is formed on the contact layer 128. The surface coating layer 135 is an optical thin film used to control the reflectance of the light exiting surface H, and may be made of, for example, SiN. The change of a thickness T of the surface coating layer 135 makes it possible to change a threshold current and the slope efficiency, and this results in changing light output with a specific current value.

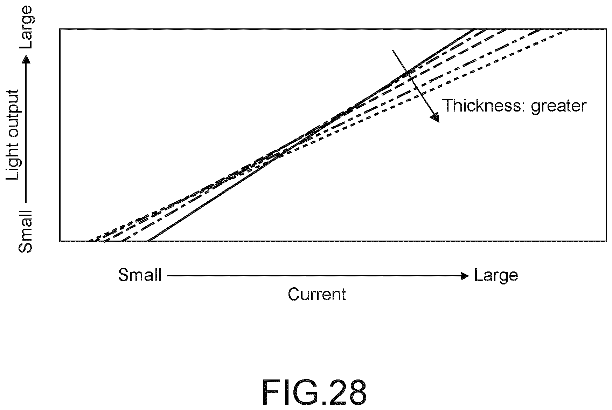

Fig. 28 is a graph illustrating an example of a relationship between the thickness T of the surface coating layer 135 and light output. As illustrated in the figure, due to the thickness T of the surface coating layer 135, light output of the light emitter 111a is changed, that is, the light extraction efficiency can be adjusted. Note that Fig. 28 illustrates an example in which light output is reduced due to the thickness T being increased, but the light extraction efficiency may be periodically changed due to the thickness T, and the reduction in the thickness T may result in an increase in light output.

In the light-emitting element 111, it is possible to make the light extraction efficiency in the third region A₃ is highest, to make the light extraction efficiency in the second region A₂ is second highest, and to make the light extraction efficiency in the first region A₁ lowest by making a difference in the thickness T of the surface-coding layer 135 between the first light emitter 111a₁, the second light emitter 111a₂, and the third light emitter 111a₃.

Consequently, the third region A₃ exhibits a highest light-emission intensity, the second region A₂ exhibits a second highest light-emission intensity, and the first region A₁ exhibits a lowest light-emission intensity. This makes it possible to provide the light-emitting element 111 in which the surrounding region exhibits a higher light-emitting intensity than the central region. In this configuration, the respective light emitters 111a have the same configuration except for the thickness of the surface coating layer 135. Thus, it is possible to form a distribution of a light-emission intensity by preparing the thickness of the surface coating layer 135, with conditions for producing the respective light emitters 111a being the same.

### {2-2. Control of Light Extraction Efficiency Performed Using Position of Boundary in Surface Coating Layers}

In the light-emitting element 111, it is also possible to make a difference in the light extraction efficiency of the light emitter 111a using a position of a boundary in surface coating layers of each light emitter 111a.

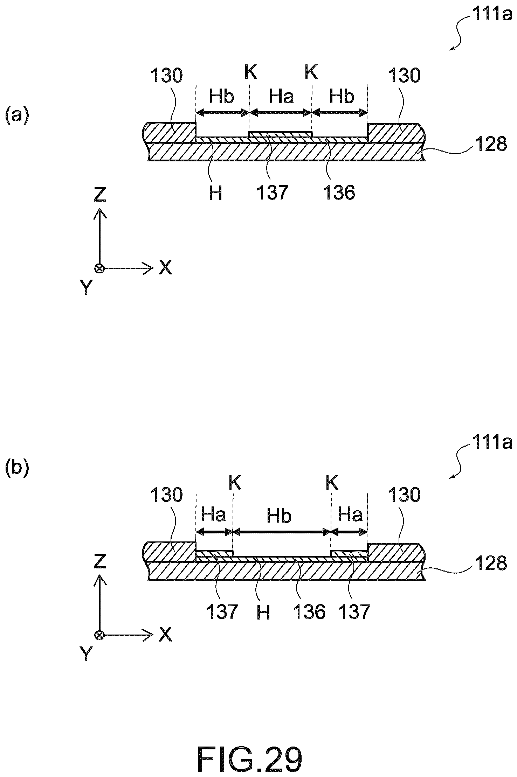

Fig. 29 is an enlarged cross-sectional view of the light emitter 111a, and illustrates a surface coating layer 136 and a surface coating layer 137 that are included in the light emitter 111a. As illustrated in (a) and (b) of Fig. 29, the surface coating layer 136 is formed on the contact layer 128, and the surface coating layer 137 is formed on a partial region of the surface coating layer 136. The surface coating layer 136 and the surface coating layer 137 are optical thin films used to control the reflectance of the light exiting surface H, and may be made of, for example, SiN.

A region, on the light exiting surface H, in which the surface coating layer 136 and the surface coating layer 137 are formed is referred to as a region Ha, and a region, on the light exiting surface H, in which only the surface coating layer 136 is formed is referred to as a region Hb. Further, a boundary between the region Ha and the region Hb is referred to as a boundary K.

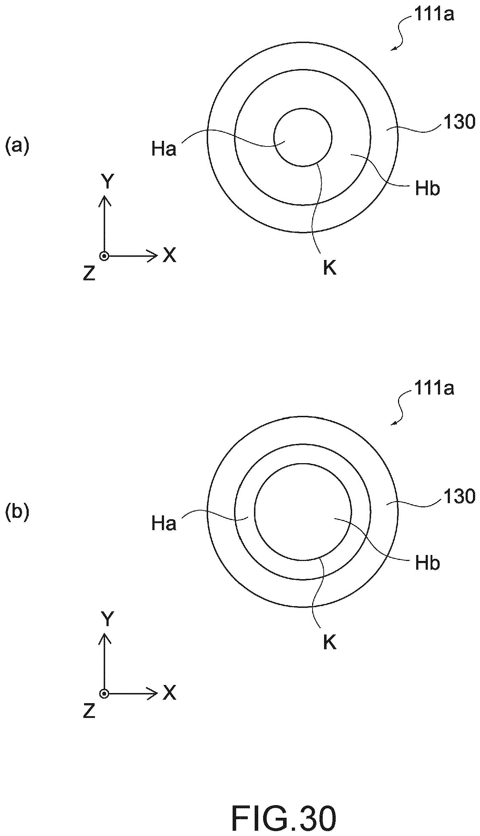

Fig. 30 is a schematic diagram illustrating the region Ha and the region Hb, where (a) of Fig. 30 is a plan view of (a) of Fig. 29, and (b) of Fig. 30 is a plan view of (b) of Fig. 29. In the light emitter 111a, an oscillation mode of light can be switched by the position of the boundary K, and a threshold current and the slope efficiency can be changed. Thus, it is possible to make the light extraction efficiency in the third region A₃ highest, to make the light extraction efficiency in the second region A₂ second highest, and to make the light extraction efficiency in the first region A₁ lowest by making a difference in a position of the boundary K between the first light emitter 111a₁, the second light emitter 111a₂, and the third light emitter 111a₃, as illustrated in (a) and (b) of Fig. 29 and (a) and (b) of Fig. 30.

Consequently, the third region A₃ exhibits a highest light-emission intensity, the second region A₂ exhibits a second highest light-emission intensity, and the first region A₁ exhibits a lowest light-emission intensity. This makes it possible to provide the light-emitting element 111 in which the surrounding region exhibits a higher light-emitting intensity than the central region. Also in this configuration, the respective light emitters 111a have the same configuration except for the configurations of the surface coating layers. Thus, it is possible to form a distribution of a light-emission intensity by preparing the position of a boundary in surface coating layers, with conditions for producing the respective light emitters 111a being the same.

Note that the region Ha and the region Hb are not limited to regions of which the numbers of surface coating layers are different. The region Ha and the region Hb may be regions of which the surface coating layers have different optical characteristics, such as regions of which the surface coating layers have different thicknesses, or regions of which the surface coating layers are made of different materials. The number of regions is also not limited to two, and may be three or more.

### {2-3. Control of Light Extraction Efficiency Performed Using DBR Layer Reflectance}

In the light-emitting element 111, it is also possible to make a difference in the light extraction efficiency of the light emitter 111a using one of the reflectance of the n-DBR layer 122 and the reflectance of the p-DBR layer 127, or both of them.

As described above, when voltage is applied between the anode 141 and the cathode 151 in the light emitter 111a, spontaneous-emission light emitted by the active layer 124 is reflected off the n-DBR layer 122 and the p-DBR layer 127, and is lased to be emitted from the light exiting surface H. Thus, the light extraction efficiency in the third region A₃ can be made highest, the light extraction efficiency in the second region A₂ can be made second highest, and the light extraction efficiency in the first region A₁ can be made lowest by making a difference in the reflectance of the n-DBR layer 122 and the reflectance of the p-DBR layer 127 in the light emitter 111a between the first light emitter 111a₁, the second light emitter 111a₂, and the third light emitter 111a₃.

Consequently, the third region A₃ exhibits a highest light-emission intensity, the second region A₂ exhibits a second highest light-emission intensity, and the first region A₁ exhibits a lowest light-emission intensity. This makes it possible to provide the light-emitting element 111 in which the surrounding region exhibits a higher light-emitting intensity than the central region.

As described above, the light-emitting element 111 in which the surrounding region exhibits a higher light-emitting intensity than the central region can be provided using a difference in light extraction efficiency between the first region A₁, the second region A₂, and the third region A₃.

Note that, with respect to the method for making a difference in light extraction efficiency between the first light emitter 111a₁, the second light emitter 111a₂, and the third light emitter 111a₃, only one of the control performed using a thickness of a surface coating layer, the control performed using a position of a boundary in surface coating layers, and the control performed using a DBR layer reflectance described above may be used, or two or more thereof may be used in combination.

Further, the light-emitting element 111 in which the light extraction efficiency in the third region A₃ is highest, the light extraction efficiency in the second region A₂ is second highest, and the light extraction efficiency in the first region A₁ is lowest can also be provided by a method that is different from the respective methods described above.

### [Regarding Shape of Distribution of Light-Emission Intensity]

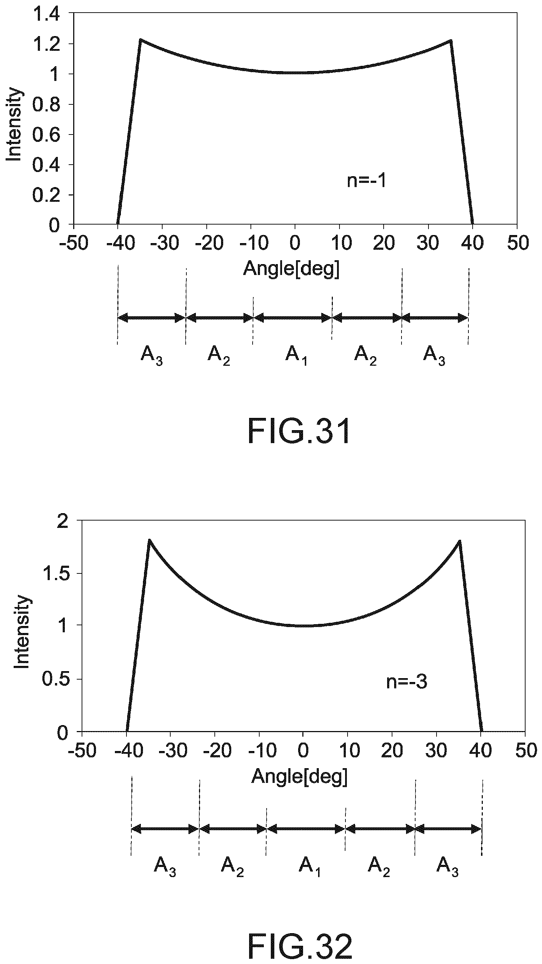

An example of a distribution of a light-emission intensity of the light-emitting element 111 is described. Fig. 31 is a graph illustrating an example of a distribution of a light-emission intensity of the light-emitting element 111. As illustrated in the figure, the distribution of a light-emission intensity of the light emitter 111 shows that the first region A₁ corresponding to the central region exhibits a low light-emission intensity, and the third region A₃ corresponding to the surrounding region exhibits a high light-emission intensity.

Here, the distribution of a light-emission intensity illustrated in Fig. 31 has a shape represented by cos⁻¹θ. The distribution of a light-emission intensity of the light-emitting element 111 is not limited to having the shape represented by cos⁻¹θ, and it is favorable that the distribution of a light-emission intensity of the light-emitting element 111 have a shape represented by cosⁿθ. Figs. 32 to 34 are graphs respectively illustrating other examples of the distribution of a light-emission intensity of the light-emitting element 111.

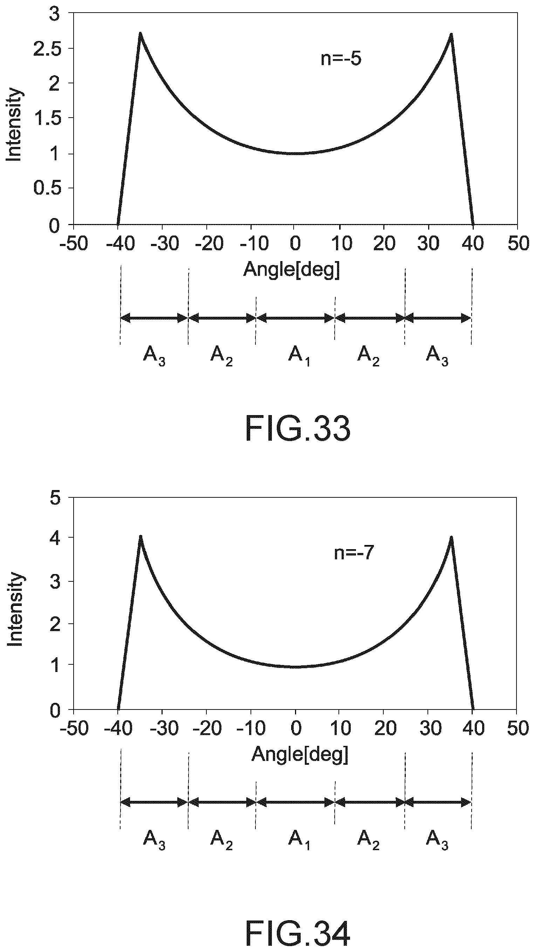

The distribution of a light-emission intensity may have a shape represented by cos⁻³θ, as illustrated in Fig. 32, or may have a shape represented by cos⁻⁵θ, as illustrated in Fig. 33. Further, the distribution of a light-emission intensity may have a shape represented by cos⁻⁷θ, as illustrated in Fig. 34.

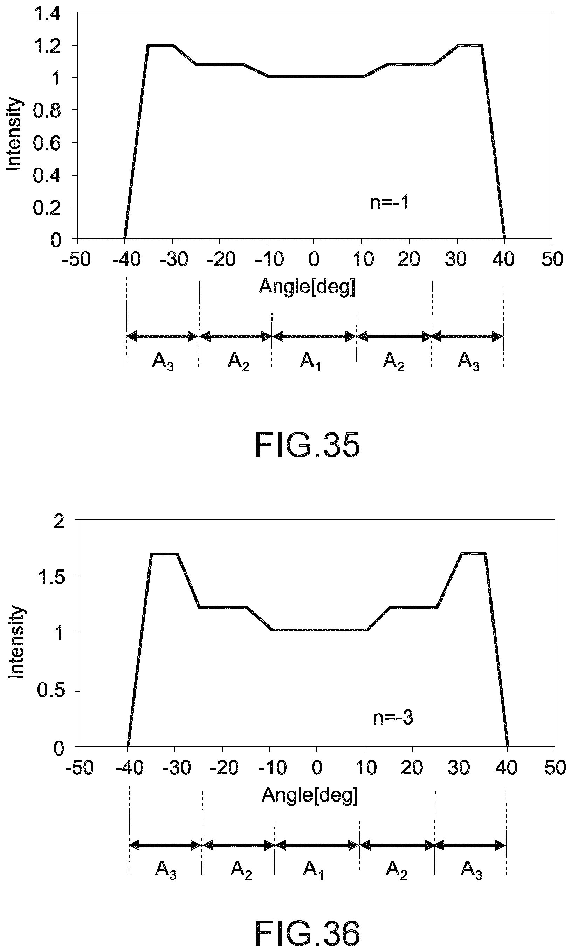

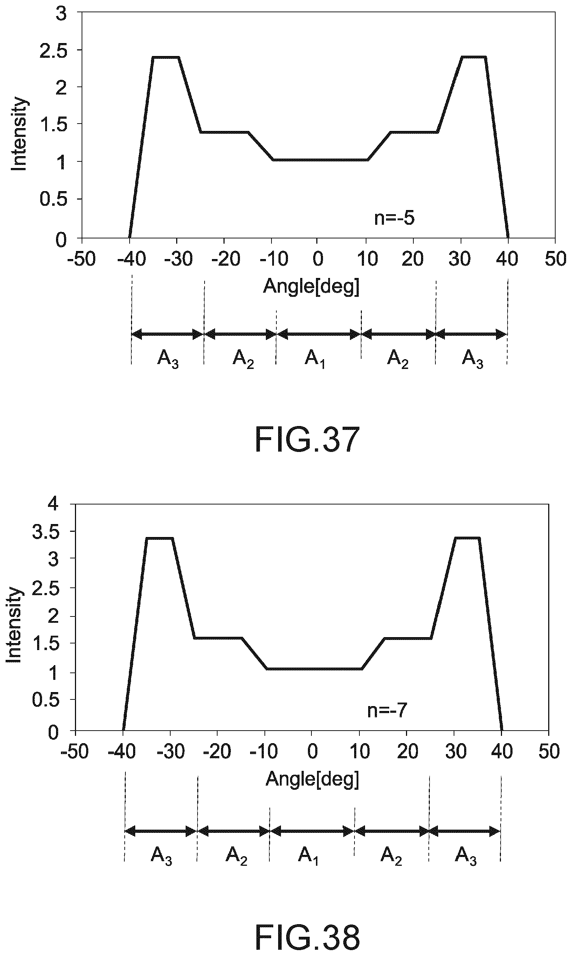

Further, the distribution of a light-emission intensity of the light-emitting element 111 is not limited to being curved, as illustrated in Figs. 31 to 34. Figs. 35 to 38 are schematic diagrams respectively illustrating other examples of the distribution of a light-emission intensity of the light-emitting element 111. As illustrated in the figures, the light-distribution of a light-emission intensity of the light-emitting element 111 may have a step shape that approximates the shape represented by cosⁿθ.

### [Effects Provided by Light-Emitting Element]

As described above, in the light-emitting element 111, the light-emission intensity in the third region A₃ can be made highest, the light-emission intensity in the second region A₂ can be made second highest, and the light-emission intensity in the first region A₁ can be made lowest by controlling a resistance of a current path that passes through each light emitter 111a or the efficiency in extracting light emitted by each light emitter 111a. This makes it possible to compensate for a reduction in the light-receiving sensitivity for light (the reflected light L_{R1} in Fig. 11) that enters the light-receiving unit 103 from a wide angle of field, and to prevent a reduction in the accuracy in ranging performed with respect to a surrounding region in a measurement-target range. Further, there is no need to add a component, to increase component costs, and to make a component larger in size, in order to obtain such a distribution of a light-emission intensity.

Further, it is possible to form a distribution of a light-emission intensity using a difference in path resistance or a difference in light extraction efficiency, with the respective light emitters 111a being connected to the anode 141 and the cathode 151 in common. In other words, there is no need to adjust applied power by an anode and a cathode being connected to each individual light emitter 111a, in order to form the distribution of a light-emission intensity. Consequently, there is no need to arrange a plurality of drive sources for the light emitters 111a, and this makes it possible to prevent component costs from being increased due to such an arrangement and to prevent the ranging apparatus 100 from becoming larger in size due to such an arrangement.

Furthermore, the present technology is also effective when an anode and a cathode are connected to each individual light emitter 111a, and the respective light emitters 111a are individually driven. There is a possibility that a driver that drives each light emitter 111a will not have a parameter used to set power for the light emitter 111a, or only a unified parameter can be used. Even in such a case, it is possible to form the distribution of a light-emission intensity in the light-emitting element 111 by supplying equivalent power to the anode 141 and the cathode 151 for each light emitter 111a.

### [Modifications]

In the embodiments described above, there is a difference in the light-emission intensity of the light emitter 111a between three regions that are the first region A₁, the second region A₂, and the third region A₃ (refer to Figs. 12 and 13). However, the number of regions is not limited to three, and the number of regions may be two or four or more. The light-emitting element 111 in which a surrounding region of the light-emitting element 111 exhibits a high light-emitting intensity and a central region of the light-emitting element 111 exhibits a low light-emitting intensity regardless of the number of regions, makes it possible to prevent a reduction in the accuracy in ranging performed with respect to a surrounding region in a measurement-target range of the light-receiving unit 103.

Further, the example in which, in the light-emitting element 111, the n-type portion is situated on the side of the substrate 121 (a lower side in Fig. 6), and the p-type portion is situated on the side of the light exiting surface H (an upper side in Fig. 6) has been described above, but the positions of the n-type portion and the p-type portion may reverse. Furthermore, a high-resistance substrate may be used as the substrate 121, a p-type layer and an n-type layer may be provided on the substrate 121, and both of the electrodes may be taken out of one side of the substrate 121. Further, the light-emitting element 111 may be a back exit VCSEL in which the light-emitting direction is a direction of the substrate. Furthermore, the example of a GaAs substrate has been described in the embodiments above, but a GaN substrate or an InP substrate may be used depending on a target light-emission wavelength.

In addition, the example in which the light-emitting element 111 is included in the light-emitting unit 101 of the ranging apparatus 100 has been described above, but the light-emitting element 111 is not limited thereto. For example, the light-emitting element 111 may also be used as a light source for structured light of the ranging apparatus, or may be applied to uniform irradiation performed without using a diffusion plate.

Further, the light-emitting element 111 can also be used as a light source for illumination in addition to being used for the ranging apparatus. The light-emission wavelength may correspond to infrared light, ultraviolet light, or visible light, and the light-emitting element 111 can also be applied to exposure. In this case, it is also possible to correct for the angular dependence of the transmittance of an optical section (such as a lens) in an illumination optical system (the light intensity in a surrounding portion that light enters obliquely is also easily reduced in this case).

At least two of the features of the present technology described above can also be combined. In other words, the various features described in the respective embodiments may be combined discretionarily regardless of the embodiments. Further, the various effects described above are not limitative but are merely illustrative, and other effects may be provided.

### Reference Signs List

- 100: ranging apparatus
- 101: light-emitting unit
- 102: light emission controller
- 103: light-receiving unit
- 104: ranging calculation section
- 111: light-emitting element
- 111a: light emitter
- 111a₁: first light emitter
- 111a₂: second light emitter
- 111a₃: third light emitter
- 122: n-DBR layer
- 123: n-cladding layer
- 124: active layer
- 125: p-cladding layer
- 126: current confinement layer
- 126a: confinement region
- 126b: injection region
- 127: p-DBR layer
- 128: contact layer
- 129: insulation layer
- 130: p-electrode
- 131: n-electrode
- 135: surface coating layer
- 136: surface coating layer
- 137: surface coating layer
- 141: anode
- 151: cathode

## Claims

1. A light-emitting element (111), comprising:
a plurality of light emitters (111a) one-dimensionally or two-dimensionally arranged in a direction that is vertical to an optical axis corresponding to light that exits each of the plurality of light emitters, each of the plurality of light emitters being a vertical-cavity surface-emitting laser element, each of the plurality of light emitters including a first electrode (130) and a second electrode (131), each of the plurality of light emitters emitting the light due to current flowing from the first electrode to the second electrode;
a first electrode terminal (141) that is electrically connected to the first electrode; and
a second electrode terminal (151) that is electrically connected to the second electrode, wherein
a first current path from the first electrode terminal to the second electrode terminal that passes through a first one of the plurality of light emitters exhibits a first electrical resistance different from a second electrical resistance of a second current path from the first electrode terminal to the second electrode terminal that passes through a second one of the plurality of light emitters, wherein the first and second current paths are parallel circuit paths.

2. The light-emitting element according to claim 1, wherein
the light-emitting element has a central region and a surrounding region, as viewed from a direction extending in parallel with the optical axis, the central region including the light emitter situated in an inner portion of the plurality of light emitters, the surrounding portion including the light emitter situated in an outer portion of the plurality of light emitters, and
the current path passing through the light emitter being included in the plurality of light emitters and being situated in the central region exhibits a higher electrical resistance than the current path passing through the light emitter being included in the plurality of light emitters and being situated in the surrounding region.

3. The light-emitting element according to claim 1, wherein
each of the plurality of light emitters includes
a first distributed Bragg reflector (DBR) layer that is electrically connected to the first electrode,
a second DBR layer that is electrically connected to the second electrode,
a current confinement layer that is arranged between the first DBR layer and the second DBR layer, and
an active layer that is arranged between the first DBR layer and the second DBR layer, and emits light due to current on which confinement has been performed by the current confinement layer,
the current confinement layer has a confinement region, and an injection region that has a higher conductivity than the confinement region, and
the electrical resistance of the current path of the light emitter of the plurality of light emitters differs depending on a size of an aperture diameter that is a diameter of the injection region.

4. The light-emitting element according to claim 3, wherein
each of the plurality of light emitters has a mesa structure in which at least the first DBR layer, the current confinement layer, and the active layer of the light emitter of the plurality of light emitters are spaced from at least the first DBR layer, the current confinement layer, and the active layer of the adjacent light emitter of the plurality of light emitters, and
the size of the aperture diameter differs depending on a size of a mesa diameter.

5. The light-emitting element according to claim 1, wherein
wiring that connects the first electrode terminal and one of the plurality of light emitters exhibits an electrical resistance different from an electrical resistance of wiring that connects the first electrode terminal and another of the plurality of light emitters,
the light-emitting element has a central region and a surrounding region, as viewed from a direction extending in parallel with the optical axis, the central region including the light emitter situated in an inner portion of the plurality of light emitters, the surrounding portion including the light emitter situated in an outer portion of the plurality of light emitters, and
wiring that connects the first electrode terminal and the light emitter being included in the plurality of light emitters and being situated in the central region exhibits an electrical resistance different from an electrical resistance of wiring that connects the first electrode terminal and the light emitter being included in the plurality of light emitters and being situated in the surrounding region.

6. The light-emitting element according to claim 5, wherein
the wiring connecting the first electrode terminal and the light emitter being included in the plurality of light emitters and being situated in the central region exhibits a higher electrical resistance than the wiring connecting the first electrode terminal and the light emitter being included in the plurality of light emitters and being situated in the surrounding region, and
the wiring connecting the first electrode terminal and the light emitter being included in the plurality of light emitters and being situated in the central region is longer than the wiring connecting the first electrode terminal and the light emitter being included in the plurality of light emitters and being situated in the surrounding region.

7. The light-emitting element according to claim 6, wherein
the plurality of light emitters is arranged in a plurality of lines,
the light emitters of the plurality of light emitters in each of the plurality of lines are connected to a corresponding one of a plurality of the pieces of wiring each extending from the first electrode,
the plurality of the pieces of wiring includes wiring that extends from the first electrode terminal to the central region through the surrounding region, and wiring that extends from the first electrode terminal to the surrounding region, and
the wiring extending to the central region and the wiring extending to the surrounding region exhibit different electrical resistances.

8. The light-emitting element according to claim 5, wherein
the first electrode included in the one of the plurality of light emitters exhibits a contact resistance different from a contact resistance of the first electrode included in the other of the plurality of light emitters.

9. The light-emitting element according to claim 5, wherein
each of the plurality of light emitters includes
a first DBR layer that is electrically connected to the first electrode,
a second DBR layer that is electrically connected to the second electrode,
a current confinement layer that is arranged between the first DBR layer and the second DBR layer, and
an active layer that is arranged between the first DBR layer and the second DBR layer, and emits light due to current on which confinement has been performed by the current confinement layer,
each of the plurality of light emitters has a mesa structure in which, using a separation groove, at least the first DBR layer, the current confinement layer, and the active layer of the light emitter of the plurality of light emitters are spaced from at least the first DBR layer, the current confinement layer, and the active layer of the adjacent light emitter of the plurality of light emitters, and
the separation groove provided around the one of the plurality of light emitters has a depth different from a depth of the separation groove provided around the other of the plurality of light emitters.

10. A light-emitting element according to claim 1, wherein
the first one of the plurality of light emitters has a light extraction efficiency different from a light extraction efficiency of the second one of the plurality of light emitters.

11. The light-emitting element according to claim 10, wherein
the light-emitting element has a central region and a surrounding region, as viewed from a direction extending in parallel with the optical axis, the central region including the light emitter situated in an inner portion of the plurality of light emitters, the surrounding portion including the light emitter situated in an outer portion of the plurality of light emitters, and
the light emitter being included in the plurality of light emitters and being situated in the central region has a lower light extraction efficiency than the light emitter being included in the plurality of light emitters and being situated in the surrounding region.

12. The light-emitting element according to claim 10, wherein
a surface coating layer that includes a first region and a second region is provided on a light exiting surface of each of the plurality of light emitters, the second region having optical characteristics different from optical characteristics of the first region, and
a position of a boundary between the first region and the second region in the one of the plurality of light emitters is different from a position of a boundary between the first region and the second region in the other of the plurality of light emitters.

13. The light-emitting element according to claim 10, wherein
each of the plurality of light emitters includes
a first DBR layer that is electrically connected to the first electrode,
a second DBR layer that is electrically connected to the second electrode,
a current confinement layer that is arranged between the first DBR layer and the second DBR layer, and
an active layer that is arranged between the first DBR layer and the second DBR layer, and emits light due to current on which confinement has been performed by the current confinement layer, and
reflectance of the first DBR layer of the one of the plurality of light emitters and reflectance of the second DBR layer of the one of the plurality of light emitters are respectively different from reflectance of the first DBR layer of the other of the plurality of light emitters and reflectance of the second DBR layer of the other of the plurality of light emitters.

14. The light-emitting element according to claim 2 or claim 11, wherein
a distribution of light-emission intensities of the plurality of light emitters from the central region to the surrounding region has a shape represented by cosⁿθ.

15. A ranging apparatus (100), comprising:
a light-emitting unit (101) that includes the light-emitting element (111) of claim 1;
a light-receiving unit (103) configured to detect reflected light that is light exiting the light-emitting unit; and
a ranging calculation section (104) configured to calculate a distance to a measurement target on a basis of a result of the detection performed by the light-receiving unit.

## Patentansprüche

1. Lichtemissionselement (111), umfassend:
eine Vielzahl von Lichtemittern (111a), die eindimensional oder zweidimensional in einer Richtung angeordnet sind, die vertikal zu einer optischen Achse ist, die Licht entspricht, das aus jedem der Vielzahl von Lichtemittern austritt, wobei jeder der Vielzahl von Lichtemittern ein oberflächenemittierendes Laserelement mit vertikaler Kavität ist und jeder der Vielzahl von Lichtemittern eine erste Elektrode (130) und eine zweite Elektrode (131) einschließt und jeder der Vielzahl von Lichtemittern das Licht aufgrund von Strom emittiert, der von der ersten Elektrode zu der zweiten Elektrode fließt;
einen ersten Elektrodenanschluss (141), der elektrisch mit der ersten Elektrode verbunden ist; und
einen zweiten Elektrodenanschluss (151), der elektrisch mit der zweiten Elektrode verbunden ist, wobei
ein erster Strompfad von dem ersten Elektrodenanschluss zu dem zweiten Elektrodenanschluss, der durch einen ersten der Vielzahl von Lichtemittern verläuft, einen ersten elektrischen Widerstand aufweist, der sich von einem zweiten elektrischen Widerstand eines zweiten Strompfads von dem ersten Elektrodenanschluss zu dem zweiten Elektrodenanschluss unterscheidet, der durch einen zweiten der Vielzahl von Lichtemittern verläuft, wobei der erste und der zweite Strompfad parallele Schaltungspfade sind.

2. Lichtemissionselement nach Anspruch 1, wobei
das Lichtemissionselement einen zentralen Bereich und einen umgebenden Bereich, betrachtet aus einer Richtung, die sich parallel zu der optischen Achse erstreckt, hat, wobei der zentrale Bereich den Lichtemitter einschließt, der sich in einem inneren Abschnitt der Vielzahl von Lichtemittern befindet, und der umgebende Abschnitt den Lichtemitter einschließt, der sich in einem äußeren Abschnitt der Vielzahl von Lichtemittern befindet, und
der Strompfad, der durch den Lichtemitter verläuft, der in der Vielzahl von Lichtemittern eingeschlossen ist und sich in dem zentralen Bereich befindet, einen höheren elektrischen Widerstand aufweist als der Strompfad, der durch den Lichtemitter verläuft, der in der Vielzahl von Lichtemittern eingeschlossen ist und sich in dem umgebenden Bereich befindet.

3. Lichtemissionselement nach Anspruch 1, wobei
jeder der Vielzahl von Lichtemittern einschließt:
eine erste verteilte Bragg-Reflektorschicht (DBR-Schicht), die elektrisch mit der ersten Elektrode verbunden ist,
eine zweite DBR-Schicht, die elektrisch mit der zweiten Elektrode verbunden ist,
eine Stromeingrenzungsschicht, die zwischen der ersten DBR-Schicht und der zweiten DBR-Schicht angeordnet ist, und
eine aktive Schicht, die zwischen der ersten DBR-Schicht und der zweiten DBR-Schicht angeordnet ist und aufgrund von Strom, der durch die Stromeingrenzungsschicht eingegrenzt wurde, Licht emittiert,
die Stromeingrenzungsschicht einen Eingrenzungsbereich und einen Einbringbereich hat, der eine höhere Leitfähigkeit als der Eingrenzungsbereich hat, und
der elektrische Widerstand des Strompfads des Lichtemitters der Vielzahl von Lichtemittern sich in Abhängigkeit von der Größe eines Öffnungsdurchmessers unterscheidet, der ein Durchmesser des Einbringbereichs ist.

4. Lichtemissionselement nach Anspruch 3, wobei
jeder der Vielzahl von Lichtemittern eine Mesastruktur hat, in der mindestens die erste DBR-Schicht, die Stromeingrenzungsschicht und die aktive Schicht des Lichtemitters der Vielzahl von Lichtemittern von mindestens der ersten DBR-Schicht, der Stromeingrenzungsschicht und der aktiven Schicht des benachbarten Lichtemitters der Vielzahl von Lichtemittern beabstandet sind, und
die Größe des Öffnungsdurchmessers sich je nach Größe des Mesa-Durchmessers unterscheidet.

5. Lichtemissionselement nach Anspruch 1, wobei
eine Verdrahtung, die den ersten Elektrodenanschluss und einen der Vielzahl von Lichtemittern verbindet, einen elektrischen Widerstand aufweist, der sich von einem elektrischen Widerstand einer Verdrahtung unterscheidet, die den ersten Elektrodenanschluss und einen anderen der Vielzahl von Lichtemittern verbindet,
das Lichtemissionselement einen zentralen Bereich und einen umgebenden Bereich, betrachtet aus einer Richtung, die sich parallel zu der optischen Achse erstreckt, hat, wobei der zentrale Bereich den Lichtemitter einschließt, der sich in einem inneren Abschnitt der Vielzahl von Lichtemittern befindet, und der umgebende Abschnitt den Lichtemitter einschließt, der sich in einem äußeren Abschnitt der Vielzahl von Lichtemittern befindet, und
Verdrahtung, die den ersten Elektrodenanschluss und den Lichtemitter verbindet, der in der Vielzahl von Lichtemittern eingeschlossen ist und sich in dem zentralen Bereich befindet, einen elektrischen Widerstand aufweist, der sich von dem elektrischen Widerstand der Verdrahtung unterscheidet, die den ersten Elektrodenanschluss und den Lichtemitter verbindet, der in der Vielzahl von Lichtemittern eingeschlossen ist und sich in dem umgebenden Bereich befindet.

6. Lichtemissionselement nach Anspruch 5, wobei
die Verdrahtung, die den ersten Elektrodenanschluss und den Lichtemitter verbindet, der in der Vielzahl von Lichtemittern eingeschlossen ist und sich in dem zentralen Bereich befindet, einen höheren elektrischen Widerstand aufweist als die Verdrahtung, die den ersten Elektrodenanschluss und den Lichtemitter verbindet, der in der Vielzahl von Lichtemittern eingeschlossen ist und sich in dem umgebenden Bereich befindet, und
die Verdrahtung, die den ersten Elektrodenanschluss und den Lichtemitter verbindet, der in der Vielzahl von Lichtemittern eingeschlossen ist und sich in dem zentralen Bereich befindet, länger ist als die Verdrahtung, die den ersten Elektrodenanschluss und den Lichtemitter verbindet, der in der Vielzahl von Lichtemittern eingeschlossen ist und sich in dem umgebenden Bereich befindet.

7. Lichtemissionselement nach Anspruch 6, wobei
die Vielzahl von Lichtemittern in einer Vielzahl von Leitungen angeordnet ist,
die Lichtemitter der Vielzahl von Lichtemittern in jeder der Vielzahl von Leitungen mit einem entsprechenden einer Vielzahl von den Verdrahtungsstücken verbunden sind, die sich jeweils von der ersten Elektrode erstrecken,
die Vielzahl der Verdrahtungstücke eine Verdrahtung einschließt, die sich von dem ersten Elektrodenanschluss durch den umgebenden Bereich zu dem zentralen Bereich erstreckt, und eine Verdrahtung, die sich von dem ersten Elektrodenanschluss zu dem umgebenden Bereich erstreckt, und
die Verdrahtung, die sich zu dem zentralen Bereich erstreckt und die Verdrahtung, die sich zu dem umgebenden Bereich erstreckt, unterschiedliche elektrische Widerstände aufweisen.

8. Lichtemissionselement nach Anspruch 5, wobei
die in einem der Vielzahl von Lichtemittern eingeschlossene erste Elektrode einen Kontaktwiderstand aufweist, der sich von dem Kontaktwiderstand der in dem anderen der Vielzahl von Lichtemittern eingeschlossenen ersten Elektrode unterscheidet.

9. Lichtemissionselement nach Anspruch 5, wobei
jeder der Vielzahl von Lichtemittern einschließt:
eine erste DBR-Schicht, die elektrisch mit der ersten Elektrode verbunden ist,
eine zweite DBR-Schicht, die elektrisch mit der zweiten Elektrode verbunden ist,
eine Stromeingrenzungsschicht, die zwischen der ersten DBR-Schicht und der zweiten DBR-Schicht angeordnet ist, und
eine aktive Schicht, die zwischen der ersten DBR-Schicht und der zweiten DBR-Schicht angeordnet ist und aufgrund von Strom, der durch die Stromeingrenzungsschicht eingegrenzt wurde, Licht emittiert,
jeder der Vielzahl von Lichtemittern eine Mesastruktur hat, in der unter Verwendung einer Trennrille mindestens die erste DBR-Schicht, die Stromeingrenzungsschicht und die aktive Schicht des Lichtemitters der Vielzahl von Lichtemittern von mindestens der ersten DBR-Schicht, der Stromeingrenzungsschicht und der aktiven Schicht des benachbarten Lichtemitters der Vielzahl von Lichtemittern beabstandet sind, und
die um einen der Vielzahl von Lichtemittern herum bereitgestellte Trennrille eine Tiefe hat, die sich von der Tiefe der um den anderen der Vielzahl von Lichtemittern herum bereitgestellten Trennrille unterscheidet.

10. Lichtemissionselement nach Anspruch 1, wobei
der erste der Vielzahl von Lichtemittern einen Wirkungsgrad der Lichtextraktion hat, der sich von dem Wirkungsgrad der Lichtextraktion des zweiten der Vielzahl von Lichtemittern unterscheidet.

11. Lichtemissionselement nach Anspruch 10, wobei
das Lichtemissionselement einen zentralen Bereich und einen umgebenden Bereich, betrachtet aus einer Richtung, die sich parallel zu der optischen Achse erstreckt, hat, wobei der zentrale Bereich den Lichtemitter einschließt, der sich in einem inneren Abschnitt der Vielzahl von Lichtemittern befindet, und der umgebende Abschnitt den Lichtemitter einschließt, der sich in einem äußeren Abschnitt der Vielzahl von Lichtemittern befindet, und
der Lichtemitter, der in der Vielzahl von Lichtemittern eingeschlossen ist und sich in dem zentralen Bereich befindet, einen geringeren Wirkungsgrad der Lichtextraktion hat als der Lichtemitter, der in der Vielzahl von Lichtemittern eingeschlossen ist und sich in dem umgebenden Bereich befindet.

12. Lichtemissionselement nach Anspruch 10, wobei
eine Oberflächenbeschichtungsschicht, die einen ersten Bereich und einen zweiten Bereich einschließt, auf einer Lichtaustrittsoberfläche jedes der Vielzahl von Lichtemittern bereitgestellt ist, wobei der zweite Bereich optische Eigenschaften hat, die sich von den optischen Eigenschaften des ersten Bereichs unterscheiden, und
eine Position einer Grenze zwischen dem ersten Bereich und dem zweiten Bereich in einem der Vielzahl von Lichtemittern sich von einer Position einer Grenze zwischen dem ersten Bereich und dem zweiten Bereich in dem anderen der Vielzahl von Lichtemittern unterscheidet.

13. Lichtemissionselement nach Anspruch 10, wobei
jeder der Vielzahl von Lichtemittern einschließt:
eine erste DBR-Schicht, die elektrisch mit der ersten Elektrode verbunden ist,
eine zweite DBR-Schicht, die elektrisch mit der zweiten Elektrode verbunden ist,
eine Stromeingrenzungsschicht, die zwischen der ersten DBR-Schicht und der zweiten DBR-Schicht angeordnet ist, und
eine aktive Schicht, die zwischen der ersten DBR-Schicht und der zweiten DBR-Schicht angeordnet ist und aufgrund von Strom, der durch die Stromeingrenzungsschicht eingegrenzt wurde, Licht emittiert, und
der Reflexionsgrad der ersten DBR-Schicht des einen der Vielzahl von Lichtemittern und der Reflexionsgrad der zweiten DBR-Schicht des einen der Vielzahl von Lichtemittern sich jeweils von dem Reflexionsgrad der ersten DBR-Schicht des anderen der Vielzahl von Lichtemittern und dem Reflexionsgrad der zweiten DBR-Schicht des anderen der Vielzahl von Lichtemittern unterscheiden.

14. Lichtemissionselement nach Anspruch 2 oder Anspruch 11, wobei
eine Verteilung der Lichtemissionsintensitäten der Vielzahl von Lichtemittern von dem zentralen Bereich zu dem umgebenden Bereich eine Form hat, die durch cosⁿθ dargestellt ist.

15. Entfernungsmessanordnung (100), umfassend:
eine Lichtemissionseinheit (101), die das Lichtemissionselement (111) nach Anspruch 1 einschließt;
eine Lichtempfangseinheit (103), die so konfiguriert ist, dass sie reflektiertes Licht erkennt, bei dem es sich um Licht handelt, das aus der Lichtemissionseinheit austritt; und
einen Entfernungsberechnungsausschnitt (104), der so konfiguriert ist, dass er eine Distanz zu einem Messziel auf Grundlage eines Ergebnisses der von der Lichtempfangseinheit durchgeführten Erkennung berechnet.

## Revendications

1. Élément émetteur de lumière (111), comprenant :
une pluralité d'émetteurs de lumière (111a) agencés de façon unidimensionnelle ou de façon bidimensionnelle dans une direction qui est verticale par rapport à un axe optique correspondant à de la lumière qui sort de chacun parmi la pluralité d'émetteurs de lumière, chacun parmi la pluralité d'émetteurs de lumière étant un élément laser à cavité verticale émettant par la surface, chacun parmi la pluralité d'émetteurs de lumière comportant une première électrode (130) et une seconde électrode (131), chacun parmi la pluralité d'émetteurs de lumière émettant la lumière en raison d'un courant circulant de la première électrode à la seconde électrode ;
une borne de première électrode (141) qui est connectée électriquement à la première électrode ; et
une borne de seconde électrode (151) qui est connectée électriquement à la seconde électrode, dans lequel
un premier trajet de courant allant de la borne de première électrode à la borne de seconde électrode qui passe à travers un premier parmi la pluralité d'émetteurs de lumière présente une première résistance électrique différente d'une seconde résistance électrique d'un second trajet de courant allant de la borne de première électrode à la borne de seconde électrode qui passe à travers un second parmi la pluralité d'émetteurs de lumière, dans lequel les premier et second trajets de courant sont des trajets de circuit parallèles.

2. Élément émetteur de lumière selon la revendication 1, dans lequel
l'élément émetteur de lumière a une région centrale et une région environnante, comme visualisé à partir d'une direction s'étendant en parallèle avec l'axe optique, la région centrale comportant l'émetteur de lumière situé dans une partie interne de la pluralité d'émetteurs de lumière, la partie environnante comportant l'émetteur de lumière situé dans une partie externe de la pluralité d'émetteurs de lumière, et
le trajet de courant passant à travers l'émetteur de lumière étant inclus dans la pluralité d'émetteurs de lumière et étant situé dans la région centrale présente une résistance électrique plus élevée que le trajet de courant passant à travers l'émetteur de lumière étant inclus dans la pluralité d'émetteurs de lumière et étant situé dans la région environnante.

3. Élément émetteur de lumière selon la revendication 1, dans lequel
chacun parmi la pluralité d'émetteurs de lumière comporte
une première couche de réflecteur de Bragg distribué (DBR) qui est connectée électriquement à la première électrode,
une seconde couche DBR qui est connectée électriquement à la seconde électrode,
une couche de confinement de courant qui est agencée entre la première couche DBR et la seconde couche DBR, et
une couche active qui est agencée entre la première couche DBR et la seconde couche DBR, et émet de la lumière en raison d'un courant sur lequel un confinement a été mis en oeuvre par la couche de confinement de courant,
la couche de confinement de courant a une région de confinement, et une région d'injection qui a une conductivité plus élevée que la région de confinement, et
la résistance électrique du trajet de courant de l'émetteur de lumière parmi la pluralité d'émetteurs de lumière diffère en dépendance d'une taille d'un diamètre d'ouverture qui est un diamètre de la région d'injection.

4. Élément émetteur de lumière selon la revendication 3, dans lequel
chacun parmi la pluralité d'émetteurs de lumière a une structure mésa dans laquelle au moins la première couche DBR, la couche de confinement de courant et la couche active de l'émetteur de lumière parmi la pluralité d'émetteurs de lumière sont espacées au moins de la première couche DBR, de la couche de confinement de courant et de la couche active de l'émetteur de lumière adjacent parmi la pluralité d'émetteurs de lumière, et
la taille du diamètre d'ouverture diffère en dépendance d'une taille d'un diamètre mésa.

5. Élément émetteur de lumière selon la revendication 1, dans lequel
un câblage qui connecte la borne de première électrode et l'un parmi la pluralité d'émetteurs de lumière présente une résistance électrique différente d'une résistance électrique d'un câblage qui connecte la borne de première électrode et un autre parmi la pluralité d'émetteurs de lumière,
l'élément émetteur de lumière a une région centrale et une région environnante, comme visualisé à partir d'une direction s'étendant en parallèle avec l'axe optique, la région centrale comportant l'émetteur de lumière situé dans une partie interne de la pluralité d'émetteurs de lumière, la partie environnante comportant l'émetteur de lumière situé dans une partie externe de la pluralité d'émetteurs de lumière, et
un câblage qui connecte la borne de première électrode et l'émetteur de lumière étant inclus dans la pluralité d'émetteurs de lumière et étant situé dans la région centrale présente une résistance électrique différente d'une résistance électrique d'un câblage qui connecte la borne de première électrode et l'émetteur de lumière étant inclus dans la pluralité d'émetteurs de lumière et étant situé dans la région environnante.

6. Élément émetteur de lumière selon la revendication 5, dans lequel
le câblage connectant la borne de première électrode et l'émetteur de lumière étant inclus dans la pluralité d'émetteurs de lumière et étant situé dans la région centrale présente une résistance électrique plus élevée que le câblage connectant la borne de première électrode et l'émetteur de lumière étant inclus dans la pluralité d'émetteurs de lumière et étant situé dans la région environnante, et
le câblage connectant la borne de première électrode et l'émetteur de lumière étant inclus dans la pluralité d'émetteurs de lumière et étant situé dans la région centrale est plus long que le câblage connectant la borne de première électrode et l'émetteur de lumière étant inclus dans la pluralité d'émetteurs de lumière et étant situé dans la région environnante.

7. Élément émetteur de lumière selon la revendication 6, dans lequel
la pluralité d'émetteurs de lumière est agencée dans une pluralité de lignes,
les émetteurs de lumière de la pluralité d'émetteurs de lumière dans chacune parmi la pluralité de lignes sont connectés à l'un correspondant parmi une pluralité des pièces de câblage s'étendant chacune à partir de la première électrode,
la pluralité des pièces de câblage comporte un câblage qui s'étend de la borne de première électrode à la région centrale à travers la région environnante, et un câblage qui s'étend de la borne de première électrode à la région environnante, et
le câblage s'étendant jusqu'à la région centrale et le câblage s'étendant jusqu'à la région environnante présentent des résistances électriques différentes.

8. Élément émetteur de lumière selon la revendication 5, dans lequel
la première électrode incluse dans l'un parmi la pluralité d'émetteurs de lumière présente une résistance de contact différente d'une résistance de contact de la première électrode incluse dans l'autre parmi la pluralité d'émetteurs de lumière.

9. Élément émetteur de lumière selon la revendication 5, dans lequel
chacun parmi la pluralité d'émetteurs de lumière comporte
une première couche DBR qui est connectée électriquement à la première électrode,
une seconde couche DBR qui est connectée électriquement à la seconde électrode,
une couche de confinement de courant qui est agencée entre la première couche DBR et la seconde couche DBR, et
une couche active qui est agencée entre la première couche DBR et la seconde couche DBR, et émet de la lumière en raison d'un courant sur lequel un confinement a été mis en oeuvre par la couche de confinement de courant,
chacun parmi la pluralité d'émetteurs de lumière a une structure mésa dans laquelle, à l'aide d'une rainure de séparation, au moins la première couche DBR, la couche de confinement de courant et la couche active de l'émetteur de lumière parmi la pluralité d'émetteurs de lumière sont espacées au moins de la première couche DBR, de la couche de confinement de courant et de la couche active de l'émetteur de lumière adjacent parmi la pluralité d'émetteurs de lumière, et
la rainure de séparation fournie autour de celui précité parmi la pluralité d'émetteurs de lumière a une profondeur différente d'une profondeur de la rainure de séparation fournie autour de l'autre parmi la pluralité d'émetteurs de lumière.

10. Élément émetteur de lumière selon la revendication 1, dans lequel
le premier parmi la pluralité d'émetteurs de lumière a une efficacité d'extraction de lumière différente d'une efficacité d'extraction de lumière du second parmi la pluralité d'émetteurs de lumière.

11. Élément émetteur de lumière selon la revendication 10, dans lequel
l'élément émetteur de lumière a une région centrale et une région environnante, comme visualisé à partir d'une direction s'étendant en parallèle avec l'axe optique, la région centrale comportant l'émetteur de lumière situé dans une partie interne de la pluralité d'émetteurs de lumière, la partie environnante comportant l'émetteur de lumière situé dans une partie externe de la pluralité d'émetteurs de lumière, et
l'émetteur de lumière étant inclus dans la pluralité d'émetteurs de lumière et étant situé dans la région centrale a une efficacité d'extraction de lumière plus basse que l'émetteur de lumière étant inclus dans la pluralité d'émetteurs de lumière et étant situé dans la région environnante.

12. Élément émetteur de lumière selon la revendication 10, dans lequel
une couche de revêtement de surface qui comporte une première région et une seconde région est fournie sur une surface de sortie de lumière de chacun parmi la pluralité d'émetteurs de lumière, la seconde région ayant des caractéristiques optiques différentes des caractéristiques optiques de la première région, et
une position d'une limite entre la première région et la seconde région dans l'un parmi la pluralité d'émetteurs de lumière est différente d'une position d'une limite entre la première région et la seconde région dans l'autre parmi la pluralité d'émetteurs de lumière.

13. Élément émetteur de lumière selon la revendication 10, dans lequel
chacun parmi la pluralité d'émetteurs de lumière comporte
une première couche DBR qui est connectée électriquement à la première électrode,
une seconde couche DBR qui est connectée électriquement à la seconde électrode,
une couche de confinement de courant qui est agencée entre la première couche DBR et la seconde couche DBR, et
une couche active qui est agencée entre la première couche DBR et la seconde couche DBR, et émet de la lumière en raison d'un courant sur lequel un confinement a été mis en oeuvre par la couche de confinement de courant, et
une réflectance de la première couche DBR de celui précité parmi la pluralité d'émetteurs de lumière et une réflectance de la seconde couche DBR de celui précité parmi la pluralité d'émetteurs de lumière sont respectivement différentes d'une réflectance de la première couche DBR de l'autre parmi la pluralité d'émetteurs de lumière et d'une réflectance de la seconde couche DBR de l'autre parmi la pluralité d'émetteurs de lumière.

14. Élément émetteur de lumière selon la revendication 2 ou la revendication 11, dans lequel
une distribution d'intensités d'émission de lumière de la pluralité d'émetteurs de lumière à partir de la région centrale jusqu'à la région environnante a une forme représentée par cosⁿθ.

15. Appareil de télémétrie (100), comprenant :
une unité d'émission de lumière (101) qui comporte l'élément émetteur de lumière (111) selon la revendication 1 ;
une unité de réception de lumière (103) configurée pour détecter de la lumière réfléchie qui est de la lumière sortant de l'unité d'émission de lumière ; et
une section de calcul de télémétrie (104) configurée pour calculer une distance jusqu'à une cible de mesure en fonction d'un résultat de la détection mise en oeuvre par l'unité de réception de lumière.
